# EUROPEAN PATENT APPLICATION

(11) **EP 4 811 827 A1**
(43) Date of publication of application: **23.09.2026**
(21) Application number: 26166119.3
(22) Date of filing: 19.03.2026
(51) Int. Cl.: H04R 29/00, H04R 3/04, H04S 7/00, G06N 20/00

(54) **PREDICTIVE MODEL OF SOUND QUALITY IN TELEVISIONS**

(30) Priority: 19.03.2025 US 202519084020
(71) Applicant: Roku, Inc., San Jose, CA 95110 (US)
(72) Inventor: ANDERSEN, Kasper, San Jose, 95110 (US); HALKJAER, Frederik Stauenberg Lindbjerg, San Jose, 95110 (US)
(74) Representative: Yang, Shu

(57) **Abstract**

Television sound quality has a poor reputation, sometimes due to the designs getting thinner. Common issues include distortion, clipping, muddy dialogue, and lack of bass. Some issues are due to or made worse by errors in tuning. The errors may come from improper measurements, lack of understanding, and prioritization of incorrect metrics. To address this issue, a data driven and objective predictive model is implemented to offer a consistent and scalable way to determine perceived sound quality of a wide range of audio systems. The predictive model can be used to determine optimal tuning parameters that would yield the best perceived sound quality of the audio system.

## Description

### Technical Field

This disclosure relates generally to audio systems, and more specifically, to a predictive model that can predict perceived sound quality of an audio system.

### Brief Description of the Drawings

Embodiments will be readily understood by the following detailed description in conjunction with the accompanying drawings. To facilitate this description, like reference numerals designate like structural elements. Embodiments are illustrated by way of example, and not by way of limitation, in the figures of the accompanying drawings.
FIG. 1 illustrates a television with an integrated audio system and exemplary external audio systems coupled to the television, according to some embodiments of the disclosure.
FIG. 2 illustrates components in a multimedia system, according to some embodiments of the disclosure.
FIG. 3 illustrates an audio system, according to some embodiments of the disclosure.
FIG. 4 illustrates applying a perceived quality model and a tuning action recommendation system to improve a score, according to some embodiments of the disclosure.
FIG. 5 illustrates an exemplary horizontal contour response of an external audio system, according to some embodiments of the disclosure.
FIG. 6 illustrates an exemplary horizontal contour response of an integrated audio system, according to some embodiments of the disclosure.
FIG. 7 illustrates an objective measurement system, according to some embodiments of the disclosure.
FIG. 8 illustrates a perceived quality model, according to some embodiments of the disclosure.
FIG. 9 illustrates a tuning action recommendation system, according to some embodiments of the disclosure.
FIG. 10 illustrates a tuning as a service system, according to some embodiments of the disclosure.
FIG. 11 depicts a flow diagram illustrating a method for predicting a perceived quality score, according to some embodiments of the disclosure.
FIG. 12 depicts a flow diagram illustrating a method for optimizing a perceived quality score, according to some embodiments of the disclosure.
FIG. 13 is a block diagram of an exemplary computing device, according to some embodiments of the disclosure.
FIGS. 14A-B depict data plots of an integrated audio system without tuning, according to some embodiments of the disclosure.
FIGS. 15A-B depict data plots of an integrated audio system with tuning, according to some embodiments of the disclosure.
FIG. 16A depicts an exemplary horizontal contour response of an integrated audio system, according to some embodiments of the disclosure.
FIG. 16B depicts an exemplary sound field deviation plotted over frequency of the integrated audio system, according to some embodiments of the disclosure.
FIG. 17A depicts an exemplary horizontal contour response of an external audio system, according to some embodiments of the disclosure.
FIG. 17B depicts an exemplary sound field deviation plotted over frequency of the external audio system, according to some embodiments of the disclosure.
FIG. 18A depicts an exemplary power averaged frequency response, according to some embodiments of the disclosure.
FIG. 18B depicts an exemplary power averaged frequency response with extrapolated high-pass, according to some embodiments of the disclosure.
FIG. 19A depicts an exemplary power averaged frequency response, according to some embodiments of the disclosure.
FIG. 19B depicts an exemplary power averaged frequency response with smoothed denoised model, according to some embodiments of the disclosure.
FIG. 20A depicts an exemplary power averaged frequency response, according to some embodiments of the disclosure.
FIG. 20B depicts an exemplary power averaged frequency response with smoothed denoised model, according to some embodiments of the disclosure.
FIG. 21A depicts an exemplary power averaged frequency response, according to some embodiments of the disclosure.
FIG. 21B depicts an exemplary power averaged frequency response, according to some embodiments of the disclosure.

### Detailed Description

### Overview

Television sound quality has a poor reputation, sometimes due to the designs getting thinner. An audio system integrated in a television is often mounted in the back of the display, and points downwards. In a typical setting, the television can be mounted on a wall and/or the end user is at a distance in front of the display. As a result, the sound of the integrated audio system cannot be delivered directly to the user. Common audio or sound quality issues include distortion, clipping, muddy dialogue, and lack of bass. These issues can significantly degrade the quality and value of a product.

An audio system can include audio processing that can be tuned or adjusted to change and improve the sound quality. Unfortunately, some issues are due to or made worse by errors in tuning. The errors may come from improper measurements of the audio system, lack of understanding of the audio system and the measurements, and prioritization of incorrect metrics.

An equipment manufacturer may not have resources to carry out extensive blind listening tests to assess sound quality of a given audio system. Such equipment manufacturers are less likely to have resources to iterate and tune parameters of the audio system to improve the sound quality. Moreover, the unpredictability and complexity of the tuning process can deter equipment manufacturers from adding technical capabilities or components, such as an audio digital signal processor to the audio system to improve audio quality.

Some models have been developed to evaluate a small set of passive loudspeakers with good direct sound. The models can take objective measurements and output a predicted sound quality score. However, these models do not perform well with audio systems with atypical directivities, such as integrated audio systems in televisions. Also, some of these models assume constant or unchanging low frequency response, which is not a realistic assumption if a model is to be applied to predict sound quality for a wide range of audio systems, e.g., from audio systems of very low-quality, to audio systems of very high-quality. Moreover, some of these models chose to ignore non-linearities. As a result, the models fail to expose and consider key variables when predicting sound quality.

To address this issue, a data driven and objective predictive model is implemented to offer a consistent and scalable way to determine perceived sound quality of a wide range of audio systems. The predictive model is also referred to herein as perceived quality model or perceived sound quality model. Objective measurements are made on a wide variety of audio systems, including audio systems integrated in televisions. Blind listening tests of the wide variety of audio systems are conducted to collect subjective perceived sound quality scores. The objective measurements and subjective perceived sound quality scores are used as training data to obtain the predictive model. Specifically, parameters of the predictive model are determined or updated based on the training data. One or more suitable techniques can be implemented to derive the parameters of the predictive model. In some cases, the predictive model includes a multivariate linear regression model. In some cases, the predictive model includes a machine learning model.

Notably, the predictive model revealed insights that some variables, e.g., objective measurements relating to spatial variability and non-linearity (which other models failed to consider), can contribute to the final perceived sound quality score.

In some embodiments, one of the objective measurements is a spatial variance measurement. The spatial variance measurement can quantify variations of sound pressure level (SPL) across frequency and space. The spatial variance measurement can quantify point-to-point variations of SPL across the frequency and spatial dimensions. The spatial variance measurement represents a significant departure from other models, which utilize spatially averaged measurements.

In some embodiments, an objective measurement may relate to spatial characteristics of the audio system. Examples of such objective measurements may include a direct sound balance, a direct sound quality measurement quantifying a flatness or an amount of errors in a frequency response of direct sound, a power balance measurement over both direct sound and indirect sound, a power quality measurement quantifying a flatness or an amount of errors in a frequency response of both direct sound and indirect sound, and a forward directivity measurement quantifying a frequency-dependent ratio between direct sound and indirect sound.

In some embodiments, an objective measurement may relate to non-linearity characteristics of the audio system. Examples of such objective measurements may include an intermodulation distortion score, a volume displacement measurement quantifying how loud the audio system can produce an audio output and maintain a level of performance, and a low frequency extension measurement quantifying a lowest frequency the audio system can produce an audio output and maintain a level of performance.

One implementation of the predictive model utilizing one or more spatial measurements can achieve an R-squared value of 0.792. Another implementation of the predictive model utilizing one or more non-linearity measurements can achieve an R-squared value of 0.8374.

The predictive model can be used to determine optimal tuning parameters that would yield the best perceived sound quality of the audio system. The result is a tuning process that does not require extensive blind listening tests and involves using a computing system to find a solution to an optimization problem. In particular, the predictive model can be used as the objective function of the optimization problem. Tuning/adjusting parameters, such as parameters that control the audio processing of the audio system, can cause different sets of objective measurements to be generated or produced by the audio system or a model of the audio system. The objective measurements can be measured using a physical audio system having certain parameters applied. The objective measurements can be modeled based on a model of an audio system having certain parameters applied. The different sets of objective measurements can be input into the predictive model to obtain different predicted sound quality scores. Optimal parameters can be determined based on the different predicted sound quality scores. For example, optimal parameters can be determined based on the parameters applied to produce the set of objective measurements that yielded the best predicted sound quality score by the predictive model. The optimization process can implement an algorithm to evaluate different sets of parameters and their corresponding predicted sound quality scores. Examples of the algorithm can include, such as grid search, random search, Bayesian optimization, and gradient descent. In one implementation, optimal parameters can be determined at convergence after 200 iterations of trying different parameters.

In some embodiments, the tuning process can be implemented as a service. An equipment manufacturer can use a data collection system to generate audio files capturing audio generated by an audio system to be tuned. The audio files can be transmitted via an application programming interface over a network, such as the Internet, to a tuning as a service system. The tuning as a service system can extract objective measurements from the audio files and input the objective measurements into the predictive model. The tuning as a service system can use the predictive model and a tuning action recommendation system to produce optimal parameters. The optimal parameters can be transmitted, over the network, back to the equipment manufacturer as a configuration file. The configuration file can be applied to the audio system to improve the sound quality. The tuning as a service system can allow the tuning process to continuously improve and operate independently without impacting the equipment manufacturers. Also, the tuning as a service system is scalable and accessible to more manufacturers/designers of audio systems. In addition, the tuning as a service system is deployed in one centralized location only, which can make the tuning as a service system easier to maintain.

The predictive model can produce an objective perceived sound quality score, which can be used as direct feedback to a manufacturer/designer of the audio system. The direct feedback, such as a poor perceived sound quality score, can offer the manufacturers/designers an objective evaluation of the audio system, and trigger the manufacturers/designers to implement modifications to the audio system, including changes to signal components, enclosure, and environment characteristics.

In some cases, one or more of the objective measurements, the predictive model, and/or the perceived sound quality score can be used by a tuning action recommendation system to form a recommended action to improve to perceived sound quality score. For instance, the predictive model may encode weights of a set of objective measurements of interest. The weights may indicate an objective measurement's contribution to the perceived sound quality score. A low perceived sound quality score can trigger the tuning action recommendation system to formulate an adjustment recommendation for an identified objective measurement based on the weights and the objective measurements. In some cases, the adjustment recommendation includes adjusting one or more parameters of audio processing to cause a change in an identified objective measurement. The adjustment recommendation, if implemented, can cause the predicted perceived sound quality score to improve.

### Exemplary audio systems

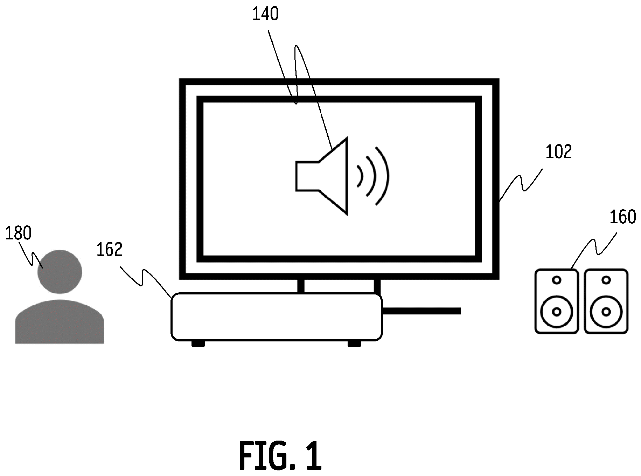

FIG. 1 illustrates television 102 with integrated audio system 140 and exemplary external audio systems coupled to the television, according to some embodiments of the disclosure. Television 102 with integrated audio system 140 and optional external audio system(s) can form a multimedia system that can deliver a multimedia experience to user 180. Television 102 may include multimedia outputs such as audio output (generated by integrated audio system 140) and display output. User 180 may be located at a distance from television 102 and can experience multimedia content delivered by television 102. Television 102 may be a smart TV system, meaning that television 102 can include compute electronics and interactive applications implemented thereon to offer advanced multimedia and interactive experiences. In addition, television 102 may have Internet connectivity to stream high-resolution content.

The front or frontside of television 102 can include a display. Exemplary displays can include Light Emitting Diode (LED) technology, Quantum Dot LED (QLED) technology, Organic Light Emitting Diode (OLED) technology, Mini-LED technology, MicroLED technology, Quantum Dot OLED (QD-OLED) technology, etc. User 180 can be in front of television 102 to view the display. Television 102 can be a flat screen television with a thin, or slim design, meaning that television 102 may not be very thick or deep. Edges around the display can be very thin, or narrow.

Integrated audio system 140 can include one or more speakers. Integrated audio system 140 can be integrated in television 102, e.g., located in the same enclosure as television 102. Locations of integrated audio system 140 within television 102 can include one or more of: bottom of television 102, back of television 102, left side of television 102, and right side of television 102. Integrated audio system 140 can include down-firing speakers located at the bottom of television 102 to direct sound downwards. The sound can reflect off surfaces like a stand or table. Integrated audio system 140 can include rear-firing speakers positioned on the back of the TV to direct sound towards the wall behind the TV. The sound then reflects off the wall and into the room. Integrated audio system 140 can include front-firing speakers. Integrated audio system 140 can include side-firing speakers located on one or more sides of the TV.

One exemplary external audio system is soundbar 162. Soundbar 162 can be a long, slim speaker system that can be mounted below or above television 102. Soundbar 162 can offer good audio quality when compared to integrated audio system 140 of FIG. 1. One exemplary external audio system is speaker system 160. Speaker system 160 can include bookshelf speakers, floor-standing speakers, satellite speakers, subwoofers, etc.

In some cases, an external audio system can include compute electronics and interactive applications implemented thereon to offer advanced multimedia and interactive experiences. In addition, the external audio system may have Internet connectivity to stream high-resolution content.

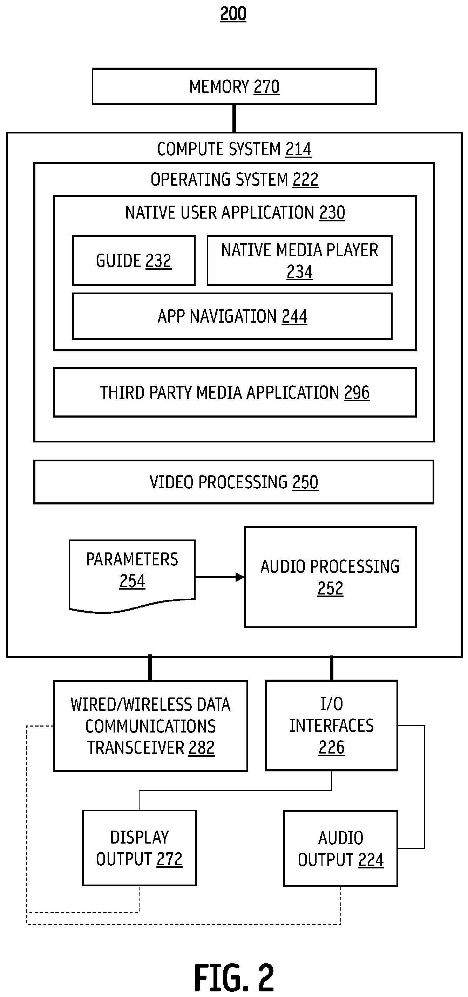

FIG. 2 illustrates components in multimedia system 200, according to some embodiments of the disclosure. Multimedia system 200 may include one or more output systems such as display output 272 and audio output 224. Display output 272 may be a part of television 102 of FIG. 1. Audio output 224 may include integrated audio system 140. Audio output 224 may include one or more external audio systems illustrated in FIG. 1.

Multimedia system 200 can include compute system 214 and memory 270 coupled to compute system 214. Compute system 214 can perform core compute functionalities of multimedia system 200 and serves as the primary computational engine. Compute system 214 can integrate multiple functional blocks, including graphics processing, video decoding, network interface management, and operating system execution.

In some cases, compute system 214 may include a system-on-chip (SoC) that integrates a central processing unit (CPU), graphics processing unit (GPU), memory, and other peripherals into a single chip. In some cases, compute system 214 may include discrete/separate integrated circuits provided on a printed circuit board, as opposed to having integrated circuits which are co-packaged together in a single chip. In some cases, compute system 214 may include one or more specialized or dedicated hardware logic blocks such as video processing 250 (e.g., implementing graphics processing algorithms and/or video codecs) and audio processing 252 (e.g., implementing audio signal processing algorithms and/or audio codecs). In some embodiments, one or more functionalities of audio processing 252 and/or video processing 250 may be implemented using one or more digital signal processors (DSPs). In some embodiments, one or more functionalities of audio processing 252 and/or video processing 250 may be implemented as software running on compute system 214.

Compute system 214 can include other components (not depicted) such as a memory integrated circuit to manage memory 270 (and/or memory internal to compute system 214), a power management integrated circuit to manage power distribution, network connectivity integrated circuit to manage network interfaces, and data controller integrated circuits to manage data interfaces, driver circuitry, voltage regulation circuitry, analog-to-digital converters, digital-to-analog converters, etc.

Memory 270 may store instructions that can be executed by components of compute system 214. Memory 270 may store data to support functionalities of compute system 214. Memory 270 may store configuration data, e.g., parameters, for components of compute system 214.

Multimedia system 200 may include one or more input/output (I/O) interfaces 226, such as data wires, physical ports, and connectors, for compute system 214 to receive input data and/or transmit output data to external devices. Examples of physical ports may include High Definition Multimedia Interface (HDMI) ports, Universal Serial Bus (USB) connection, optical audio port, audio jacks, serial data lines, etc. In some cases, display output 272 and/or audio output 224 may be communicably coupled to compute system 214 via I/O interfaces 226.

Multimedia system 200 may include wired/wireless data communications transceiver 282 for compute system 214 to receive and transmit data from a data network, such as a local network or the Internet. Examples of data communications transceivers may include Ethernet transceiver, Bluetooth transceiver, Wi-Fi transceiver, Zigbee transceiver, etc. In some cases, display output 272 and/or audio output 224 may be communicably coupled to compute system 214 via wired/wireless data communications transceiver 282.

Compute system 214 can implement operating system 222. Operating system 222 may include software to manage components of multimedia system 200 and provide a user interface for which a user can interact with multimedia system 200. Operating system 222 implements functionalities that transform display output 272 and/or audio output 224 into comprehensive multimedia and interactive computing platforms. Operating system 222 may include core system software that manages the hardware components of multimedia system 200. The core system software may include a bootloader, initialization process, kernel modules, file system manager, system libraries, memory manager, and device drivers. The core system software may include a networking stack. The core system software may include graphics and display management. The core system software may include power management processes. In addition, the core system software includes an application layer that can support a number of user applications. The application layer may include an application store that allows one or more user applications to be installed and run by operating system 222.

Operating system 222 may implement native user application 230 (e.g., native user application 230 (and parts thereof) may be pre-installed or included as part of operating system 222) that serves as the primary user interface with a user and can offer an initial set of functionalities for the user. The functionalities may include allowing a user to browse and/or search for content, allowing a user to perform device tasks, allowing a user to browse and/or search for applications, allowing a user to view media content, etc.

Native user application 230 may include guide 232. Guide 232 may be an electronic program guide (EPG). Guide 232 can include a graphical user interface displayed on a display screen that provides users with comprehensive information about current and upcoming television programs and content. Guide 232 allows users to browse channel listings, view program details like show descriptions and air times, search for specific content. Guide 232 can includes features such as scheduling recordings, setting reminders, and receiving personalized program recommendations. In some cases, guide 232 may include a graphical user interface displayed on a display screen that provides users with a visually rich, horizontally scrolling grid of content thumbnails organized by genres, recommendations, and categories like "Trending Now" or "Because You Watched." Each content tile displays a cover image, brief title, rating, and genre indicators, allowing users to quickly browse and select movies or shows through intuitive navigation using arrow keys or mouse/touch interactions, with additional hovering functionality that provides more information and quick-play options.

Native user application 230 may include native media player 234. Native media player 234 can include a graphical user interface for playing digital audio and video content, featuring playback controls like play, pause, rewind and fast forward. The graphical user interface may include a progress bar for navigating within the duration of the content. Native media player 234 can include support for various file formats.

Native user application 230 may include application navigation 244. Application navigation 244 can include a graphical user interface having a grid of tiles/icons representing applications which are installed on operating system 222. Application navigation 244 allows a user to browse and/or search for applications and launch an application by clicking or selecting a tile/icon.

Operating system 222 may implement third-party media application 296 that serves as an additional application that a user may interact with. Third-party media applications may be managed and implemented by a different company that implements operating system 222 and native user application 230. Third-party media application 296 can in some cases be pre-installed or may be installed on operating system 222 upon user request.

Audio processing 252 can be parameterizable. Audio processing 252 can perform audio processing using one or more parameters 254. Examples of audio processing algorithms implemented in audio processing 252 can include equalization (EQ), dynamic range compression, volume leveling or modeling, bass management, bass enhancement, surround sound processing, noise reduction, echo cancellation, lip sync adjustment, speaker calibration, audio effects, dialogue enhancer, wall mount compensation, media intelligence processing, temperature overload protection, excursion overload protection, loudness compensation, etc. Various audio processing algorithms can be adjusted using one or more parameters 254 that control the audio processing algorithms.

In some embodiments, audio processing 252 may include one or more linear processes, and one or more parameters 254 may be applied to modify the one or more linear processes. In one example, audio processing 252 may include a cascade of second order filters (e.g., biquads), which may be used to control the linear frequency response of audio processing 252. One or more parameters 254 that define the shape of individual filters and the number of filters can be adjusted to modify the linear frequency response of audio processing 252. In another example, audio processing 252 may include an amplifier, and one or more parameters 254 may include gain of the amplifier or volume. The gain can be adjusted to get a reasonable start level.

In some embodiments, audio processing 252 may include one or more non-linear processes, and one or more parameters 254 may be applied to modify the one or more non-linear processes. Examples of one or more parameters 254 that adjust one or more non-linear processes include compression limits, distortion limits, and level limits. Adjusting one or more parameters 254 can cause the audio to sound less destructive/altered to the listener. In one example, audio processing 252 may include applying soft clipping using a polynomial, and one or more parameters 254 may include coefficients of the polynomial. In another example, audio processing 252 may include hard clipping (if a sample is above a defined maximum amplitude, reduce the sample to that amplitude), and one or more parameters 254 may include the maximum amplitude. In another example, audio processing 252 may include compression (dynamically turning down level when a signal above a certain threshold value, and turns the level back up when the signal falls back under that threshold value). One or more parameters 254 may include the threshold value, ratio, and knee, which can define where the limit is and how much the signal is turned down. One or more parameters 254 may include attack and release, which can define how fast the level is turned down and up, respectively. Adjusting these parameters can be beneficial to turn down a signal when the signal would cause high intermodulation distortion or damage to the system. In another example, audio processing 252 may include power compression (modeling the audio system's wattage used in audio reproduction and turning the signal down until the wattage is below the maximum wattage for the audio system), and one or more parameters 254 may include the maximum wattage. In another example, audio processing 252 may include excursion compression (modeling/measuring the audio system's excursion used in audio reproduction and turning the signal down until the excursion is below the maximum excursion for the audio system), and one or more parameters 254 may include the maximum excursion. In another example, audio processing 252 may include excursion compression (modeling/measuring the audio system's temperature used in audio reproduction and turning the signal down until the temperature is below the maximum safe temperature for the audio system), and one or more parameters 254 may include the maximum safe temperature.

One or more parameters 254 can be managed with firmware that operates with audio processing 252. One or more parameters 254 can be pre-installed at factory and loaded in memory 270. In some cases, the firmware may allow one or more parameters 254 to be loaded onto memory 270. In some cases, one or more parameters 254 adjust certain values used for audio processing. In some cases, the parameters enable or disable certain audio processing algorithms, or features/settings thereof. Setting and/or adjusting one or more parameters 254 being applied by the audio processing algorithms can impact audio signals (e.g., sound quality) generated by audio processing 252, which are output to user 180 via audio output 224.

EQ algorithms in audio processing 252 can adjust the frequency response to balance output of audio output 224. EQ algorithms, or filters can include tuning bass, midrange, and treble frequencies to achieve the desired sound profile. Different types of filters can be used to target specific frequency ranges. Examples of filters can include: low-shelf filter (which boosts or cuts frequencies below a certain point), high-shelf filter (which boosts or cuts frequencies above a certain point), peak (bell) filter (which boosts or cuts frequencies around a central frequency), low-pass filter (which allows frequencies below a certain point to pass through while attenuating higher frequencies), high-pass filter (which allows frequencies above a certain point to pass through while attenuating lower frequencies), etc. Various filters can be controlled by one or more parameters 254, which may include gain (which controls the amount of boost or cut applied to a specific frequency range, in decibels (dBs)), center frequency (which controls the frequency around which the boost or cut is applied), frequency range (which controls the range of frequencies which the boost, cut, or pass is applied), Q factor or resonance/bandwidth (which controls the width of the frequency range affected by the filter), slope or roll off (which controls how steeply the filter transitions from passband to stop band), and phase shift angle (which controls an amount of phase shift to apply), etc.

Dynamic EQ algorithms in audio processing 252 can adjust the EQ settings dynamically based on the input signal's amplitude. For example, different EQ settings can be applied at different volume levels, enhancing the overall audio experience. Dynamic EQ algorithms or filters can be controlled by one or more parameters 254 such as ones described with EQ algorithms above, and parameters relating to adaptive or dynamic audio processing. Examples of one or more parameters 254 for dynamic EQ algorithms can include frequency (which sets the specific frequency or range of frequencies of interest), gain (which controls the amount of boost or cut applied to the selected frequency range), Q factor or resonance/bandwidth (which determines the width of the frequency range of interest), threshold (which sets the level or amplitude at which the dynamic EQ starts to take effect), attack time (which controls how quickly the dynamic EQ responds when the input signal exceeds the threshold), release time (which controls how quickly the EQ returns to its original state after the input signal falls below the threshold), ratio (controls the amount of gain reduction or boost applied when the input signal exceeds the threshold), and knee (which controls the transition between no processing and full processing).

Dynamic range compression or compression algorithms in audio processing 252 can manage the difference between the loudest and quietest parts of the audio signal or shape the dynamic range of the audio signal to allow for a more balanced and polished sound. Compression algorithms can be controlled by one or more parameters 254. Examples of one or more parameters 254 for dynamic range compression algorithms can include threshold (which sets the level above which the compressor starts to reduce the gain), ratio (which sets the amount of compression applied to the signal that exceeds the threshold), attack time (which controls how quickly the compressor responds after the input signal exceeds the threshold), release time (which controls how quickly the compressor stops reducing the gain after the input signal falls below the threshold), knee (which controls the transition between no compression and full compression), make-up gain (which controls the amount of boost to apply after compression to bring the compressed signal back to a desired level), and selection of a side-chain input (which selects an external signal or a portion of the signal to control the compression, such as using a voice signal can be used to compress the background music).

Volume leveling in audio processing 252 can ensure consistent volume levels across different content and sources. Volume leveling can be referred to as loudness normalization. Volume leveling can prevent sudden changes in volume when switching channels or inputs. Volume leveling algorithms can be controlled by one or more parameters 254. Examples of one or more parameters 254 for volume leveling can include target loudness (which sets the desired average loudness level for all audio content, in Loudness Units relative to Full Scale), selection of loudness measurement method (which selects the algorithm used to measure the loudness), gain adjustment (which controls the amount of gain applied to each audio track to achieve the target loudness), peak limiting (which controls the certain peak level at which the adjusted audio would not exceed to prevent clipping and distortion), etc.

Bass management in audio processing 252 can control the low frequency output to optimize bass performance. Bass management can include setting crossover frequencies and adjusting subwoofer levels. Bass management can direct low frequency audio signals to the appropriate speakers. Bass management can be controlled by one or more parameters 254. Examples of one or more parameters 254 for bass management can include crossover frequency (which determines the frequency at which the audio signal is split between the main speakers and the subwoofer), subwoofer level (which adjusts the volume of the subwoofer relative to the main speakers to ensure balanced bass output), phase adjustment (which ensures that the subwoofer and main speakers are in phase, meaning their sound waves align properly to avoid cancellation and ensure coherent bass response), and low frequency effects channel level (which sets the level of a dedicated low frequency effects channel).

Base enhancement in audio processing 252 can boost low frequencies when more excursion or power is available. Bass enhancement can make the low frequency content sound more prominent and impactful. Bass enhancement can be controlled by one or more parameters 254. Examples of one or more parameters 254 for bass enhancement can include bass boost/gain (which sets the gain of low frequency signals to make the bass more pronounced), dynamic bass enhancement parameters (which controls how to dynamically adjust bass boost/gain based on the input signal's amplitude), harmonic generation parameters (which determines what type of harmonics to add to the low frequency signals to create the perception of deeper bass without actually increasing the low frequency content), and subwoofer EQ parameters (which finetunes the frequency response of the subwoofer to match the room acoustics and the characteristics of the subwoofer itself).

Surround sound processing in audio processing 252 can enhance the spatial audio experience by processing multi-channel audio formats like Dolby Digital, DTS, or other surround sound technologies. Surround sound processing can distribute audio signals across multiple speakers. Surround sound processing can be controlled by one or more parameters 254. Examples of one or more parameters 254 for surround sound processing can include speaker configuration (which defines the number and placement of speakers in the surround sound setup, e.g., 5.1, 7.1, and 9.1.2), channel assignment (which directs specific audio signals to the appropriate speakers), crossover frequency (which determines the frequency at which audio signals are split between the main speakers and the subwoofer), delay/timing (which adjusts the delay or timing to ensure that sound from all speakers reaches the listener simultaneously), level calibration parameters (which sets the volume levels for each speaker to ensure balanced sound), room correction parameters (which adjust the audio output based on detected room acoustics), and virtual surround sound processing parameters (which controls how to simulate the effect of a full surround sound system with fewer speakers).

Noise reduction processing in audio processing 252 can reduce unwanted background noise and hiss to improve audio clarity. Noise reduction processing can remove or minimize unwanted noise from an audio signal to improve its clarity and quality. Noise reduction processing can be controlled by one or more parameters 254. Examples of one or more parameters 254 for noise reduction processing can include threshold (which sets the level at which the noise reduction algorithm starts to take effect), reduction amount (which controls the degree to which the noise is reduced, in decibels), attack time (which defines how quickly the noise reduction algorithm responds when the signal falls below the threshold), release time (which determines how quickly the noise reduction stops affecting the signal once it rises above the threshold), frequency range (which controls specific target frequency ranges to remove noise), smoothing (which can smooth out the transitions between noise reduction and the original signal, reducing artifacts and making the noise reduction less noticeable), and noise profile parameters (which characterize expected noise and is used to more accurately remove the noise).

Echo cancellation processing in audio processing 252 can reduce or minimize echo and reverberation. Echo cancellation can remove echoes from audio signals. Echo cancellation can be controlled by one or more parameters 254. Examples of one or more parameters 254 for echo cancellation can include echo path parameters (which defines the route that the original sound takes from the speaker to the microphone), adaptive filtering parameters (which defines how to continuously adjust the filter parameters to match changes in the echo path), echo return loss parameters (which measures the amount of echo that is attenuated by the echo canceller), echo return loss enhancement (which measures the additional echo attenuation provided by the echo canceller beyond the natural echo return loss), non-linear processing parameters (which specifies how to remove any residual echo that the adaptive filter cannot cancel), convergence time (which defines how quickly the echo canceller adapts to changes in the echo path), and tail length (which defines the duration of the echo that the canceller can handle.

Lip sync adjustment processing in audio processing 252 can ensure that the audio is synchronized with the video to prevent any noticeable delay. Lip sync adjustment processing can be controlled by one or more parameters 254. Examples of one or more parameters 254 for lip sync adjustment processing can include audio delay (which adjusts the timing of the audio signal), and video delay (which adjusts the timing of the video signal).

Speaker calibration algorithms in audio processing 252 can finetune the audio output based on the specific characteristics of the speakers, placement of the speakers, and room acoustics. Speaker calibration algorithms can be controlled by one or more parameters 254. Examples of one or more parameters 254 for speaker calibration algorithms can include speaker distance (which sets the distance from each speaker to the primary listening position), speaker levels (which adjust the volume level of each speaker to ensure balanced sound), crossover frequency (which sets the crossover frequency to determine the point at which low frequency sounds are redirected from the main speakers to the subwoofer), phase alignment (which ensures that all speakers, especially the subwoofer, are in phase with each other), room acoustics parameters (which causes the audio output to be adjusted according to the room), EQ response parameters (which finetunes the frequency response of each speaker to achieve a balanced sound profile), delay/timing (which adjusts the delay settings to ensure that sound from all speakers arrives at the listening position at the same time

Audio effects processing in audio processing 252 can apply various audio effects like virtual surround sound, bass boost, or dialogue enhancement to improve the overall listening experience. Audio effects processing can include dialogue enhancer (which intelligently detects and enhances dialogue in audio), wall mount compensation (which optimizes sound for a wall-mounted television), media intelligence processing (which automatically selects and applies an audio profile based on the content). Various audio effects processing can be controlled by one or more parameters 254. For example, audio effects processing may include reverb. Reverb may simulate the reflections of sound in a physical space, and one or more parameters 254 for reverb can include decay time (which specifies the duration it takes for reverb to fade away), pre-delay (which specifies the time between the original sound and the onset of the reverb), room size (which specifies the size of the simulated space), and damping (which controls the absorption of high frequencies). In another example, audio effects processing may include delay. Delay may create echoes by repeating the original sound, and one or more parameters 254 for delay can include delay time (which specifies the time interval between the original sound and the repeated sound), feedback (which specifies the amount of the delayed signal that is fed back into the delay processor), and mixing (which defines the balance between the dry and the wet signals). In another example, audio effects processing may include distortion. Distortion may add harmonic and inharmonic overtones to the audio signal, and one or more parameters 254 for distortion can include drive/gain (which controls the amount of distortion applied to the signal), tone (which adjusts the frequency response of the distorted signal), and level (which sets the level of the distorted signal). Other examples of audio effects processing algorithms can include chorus, flanger, and phaser, and one or more parameters 254 can be used to tune those audio effects processing algorithms.

Because of the complexity of algorithms in audio processing 252, the complicated interactions between the algorithms, the dynamic nature of the algorithms, and the high number of one or more parameters 254 which can be adjusted for audio processing 252 to improve sound quality, it is not trivial to determine optimal values for one or more parameters 254.

### Exemplary audio system and a model that models the audio system

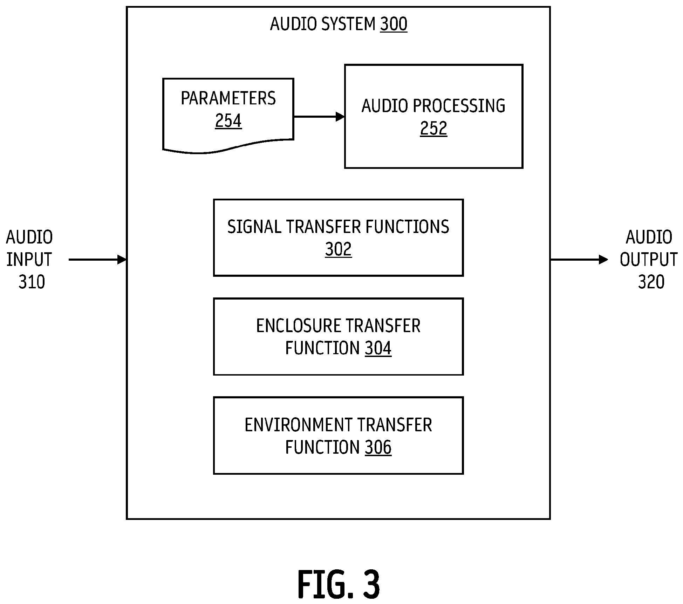

FIG. 3 illustrates audio system 300, according to some embodiments of the disclosure. Audio system 300 can receive audio input 310 (e.g., one or more audio signals) and generate audio output 320 which can be delivered to and perceived by an end user. Optimizing the sound quality of audio output 320 by adjusting or modifying various components of audio system 300 is a technically challenging task. When optimizing the sound quality of audio output 320, the initial task can include describing or defining a model of audio system 300 which captures system behavior and system characteristics of audio system 300. A model of audio system 300 can relate audio input 310 and audio output 320. A model of audio system 300 can model how audio input 310 is processed through audio system 300 to result in audio output 320. The model of audio system 300 can be a function of one or more variables relating to the components of audio system 300 that can be adjusted/modified. Audio system 300 can include a variety of components, which may be taken into account when modeling audio system 300. In one example, the model of audio system 300 can be defined as a system transfer function H(s), which may be composed of cascaded subsystems (or a product of subsystem transfer functions in the frequency domain). The subsystems of audio system 300 can include, e.g., audio processing 252, signal components, enclosure, and the environment.

Audio system 300 can include audio processing 252 and one or more parameters 254 which can be applied to control audio processing 252. Audio processing 252 and one or more parameters 254 may be taken into account in the model of audio system 300. One or more parameters 254 may be one or more variables of the subsystem transfer function. The subsystem transfer function can be composed of transfer functions of the filters (e.g., frequency responses of the filters).

Audio system 300 may include signal components that impact or are involved in the generation of audio output 320. Signal components can include electronic components, electro-mechanical, and mechanical components. Examples can include analog-to-digital converters, limiters, amplifiers, drivers, cones, magnets, voice coil, electro-mechanical transducers, etc. The signal components can be characterized by signal transfer functions 302 (which may describe linear and non-linearities of the signal components). Signal transfer functions 302 that characterize the physical components (e.g., frequency-dependent behaviors) may be taken into account in the model of audio system 300. The subsystem transfer function can be composed of signal transfer functions 302 of the signal components.

Audio system 300 may include an enclosure that impacts the delivery of audio output 320. The enclosure (e.g., having chassis, channels, ports, membranes, etc.) can be characterized by mechanical design and characteristics (e.g., resonant frequencies, vibrations, impedances, compliances and losses, wear and tear, etc.), which can be captured by enclosure transfer functions 304. Enclosure transfer functions 304 that characterize the enclosure (e.g., frequency-dependent behavior or effects) may be taken into account, e.g., as a subsystem transfer function, in the model of audio system 300.

Audio system 300 may include an environment that impacts the delivery of audio output 320 or reacts to audio output 320. The environment (e.g., room acoustic characteristics, near-field effects, early reflections, placement of audio system 300 within a room, location of walls, location of other items in environment, etc.) can be captured by environment transfer functions 306. Environment transfer functions 306 that characterize the environment (e.g., frequency-dependent behavior or effects) may be taken into account, e.g., as a subsystem transfer function, in the model of audio system 300.

Modeling audio system 300 allows for one or more optimal parameters (e.g., optimal values of one or more parameters 254) to be determined by predicting changes to the objective measurements (e.g., characteristics of audio output 320) based on the changes to the parameters and by predicting changes to the perceived sound quality score by inputting the predicted changes to the objective measurements to a perceived sound quality model. In this manner, different sets of parameters can be evaluated to find the set of parameters that yields the best or improves the perceived sound quality score.

Audio system 300 can be modeled to include one or more of: a linear process and a non-linear process. Linear processes and/or non-linear processes can affect audio reproduction. The audio system may receive an audio signal as input (e.g., audio input 310) and apply one or more linear processes and/or one or more non-linear processes to produce an audio output 320 from which objective measurements can be extracted.

Examples of linear processes in audio system 300 may include linear filters, delays, changing levels, changes in output level over the frequency spectrum when input level remains constant or frequency response, changes in time delay or phase response between input and output signals, etc. Linear processes follow the principle of superposition, where the output is directly proportional to the input, and multiple inputs result in outputs that can be added together. In linear systems, doubling the input signal exactly doubles the output with no distortion or additional artifacts. Linear processes can be modeled using transfer functions, impulse responses, and frequency domain analysis. The optimization process, when evaluating a set of parameters, can apply the set of parameters (e.g., changes/configurations to the audio system) in a linear fashion to derive a set of objective measurements that can be used as input to the perceived sound quality model because of the principle of superposition. In some cases, optimal parameters that are associated with one or more linear processes of the audio system can be determined by the optimization process.

Examples of non-linear processes in audio system 300 may include destructive filters, changing distortion, changing saturation, compression filters, changing driver excursion limits, changing power compression relating to the voice coil, modifying harmonic distortion (e.g., creating new frequencies at multiplies of the original frequency), modifying intermodulation distortion (e.g., creating sum and difference tones), etc. Non-linear processes do not maintain proportional relationships between the input and output and can create effects which are not present in the original signal. Non-linear processes are difficult to model mathematically. The optimization process, when evaluating a set of parameters, can apply the set of parameters to the audio system (e.g., changes/configurations to the audio system) to cause the audio system to produce an audio output. A set of objective measurements can be measured from the output and can be used as input to the perceived sound quality model. In some cases, optimal parameters that are associated with one or more non-linear processes of the audio system, including compressors of the audio system can be determined by the optimization process.

Having a well understood and defined model of audio system 300 can allow adjustment of one or more parameters 254 without requiring physical access to audio system 300. In some cases, a model of audio system 300 can define or describe how changing one or more parameters 254 can impact the relationship between audio input 310 and audio output 320. In some cases, a model of audio system 300 can define or describe how changing one or more parameters 254 impacts characteristics of audio output 320 (e.g., measurements of audio output 320). For example, a model of audio system 300 can include one or more linear processes, and changes in one or more parameters 254 can be predicted in a linear fashion to obtain changes in the objective measurements of audio output 320.

### Exemplary predictive perceived sound quality model and tuning system

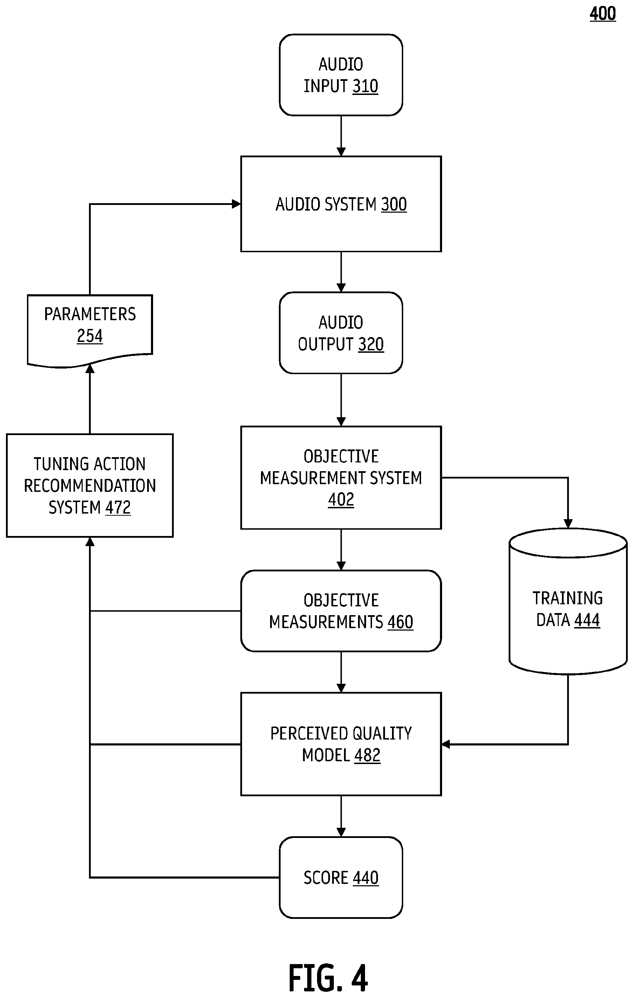

FIG. 4 illustrates process 400 involving applying perceived quality model 482 and optionally tuning action recommendation system 472 to improve a perceived sound quality score, according to some embodiments of the disclosure.

Process 400 includes audio system 300 receiving audio input 310 and producing audio output 320. In some cases, audio system 300 may include an audio system illustrated in FIG. 1. In some cases, audio system 300 is modeled using a model as discussed with FIG. 3.

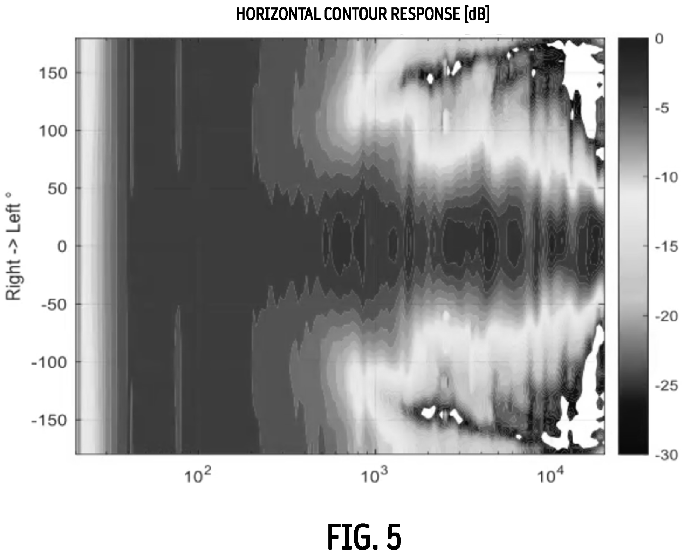

Process 400 includes objective measurement system 402 to capture audio output 320. Objective measurement system 402 can acquire or capture one or more measurements of audio output 320. The one or more measurements can include audio signals or audio files. Objective measurement system 402 can extract or derive one or more objective measurements 460 from the one or more measurements of the audio output 320. One or more objective measurements 460 can include numerical values which characterize audio output 320. One or more objective measurements 460 can represent variables which may change or differ from one audio system to another audio system. One or more objective measurements 460 can represent variables which may change or differ from when different parameter values are applied to the same audio system. Details relating to objective measurement system 402 are described further with FIGS. 5-7.

Process 400 can include providing one or more objective measurements 460 as input to perceived quality model 482 to obtain a (perceived) sound quality score 440 of audio system 300.

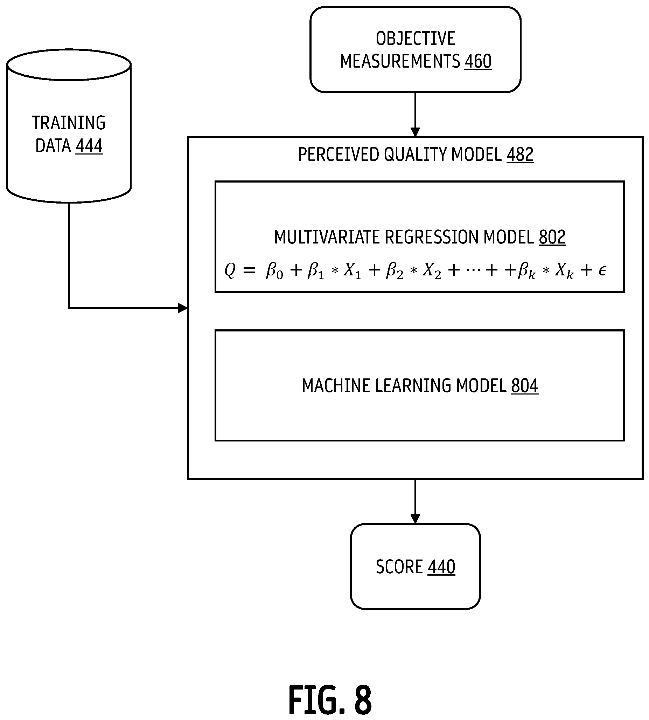

Process 400 includes using objective measurement system 402 to extract objective measurements across many different audio systems and conducting blind listening tests of the different audio systems to collect training data 444. Training data 444 includes mapping of objective measurements to subjective scores offered by listeners (e.g., a score from 1-10). In one implementation, ~80 different audio systems were tested with ~500 participants to obtain ~8000 mappings of objective measurements to subjective scores. Details relating to perceived quality model 482 and training of perceived quality model 482 using training data 444 are described further with FIG. 8.

Process 400 can include applying tuning action recommendation system 472 to generate one or more parameters 254 (e.g., optimal values for one or more parameters 254) based on one or more of: one or more objective measurements 460, information in perceived quality model 482, and sound quality score 440. In some cases, tuning action recommendation system 472 may provide sound quality score 440 as feedback to a manufacturer/designer of audio system 300. In some cases, tuning action recommendation system 472 may provide one or more objective measurements 460 as feedback to a manufacturer/designer of audio system 300. In some cases, tuning action recommendation system 472 may provide one or more tuning action recommendations as feedback to a manufacturer/designer of audio system 300.

In some cases, tuning action recommendation system 472 may determine optimal values for one or more parameters 254. Optimal values for one or more parameters 254 can be determined based on different scores produced by perceived quality model 482 based on different sets of one or more objective measurements. Tuning action recommendation system 472 can optimize the values for one or more parameters 254 to increase or improve sound quality score 440 being produced by perceived quality model 482. Tuning action recommendation system 472 can generate a configuration file having the optimal values for one or more audio processing algorithms (e.g., one or more algorithms implemented on an audio DSP) in audio system 300. The configuration file having optimal values for one or more parameters 254 can be applied to audio system 300 to improve the perceived sound quality score 440.

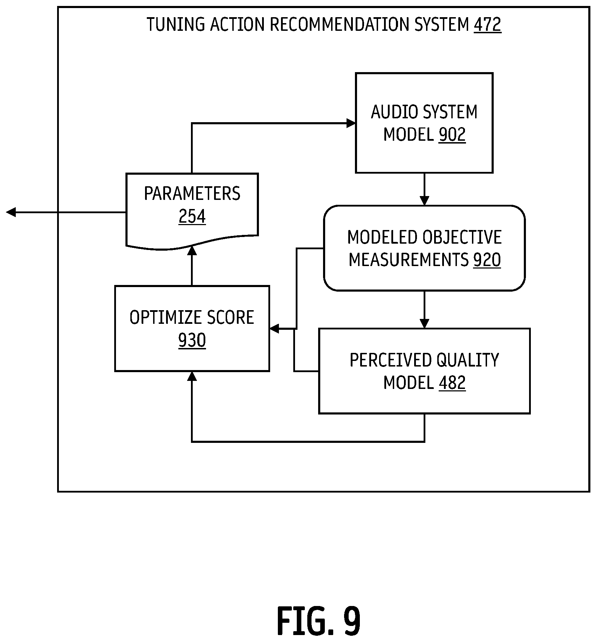

In some cases, tuning action recommendation system 472 can determine one or more recommended actions based on one or more of one or more objective measurements 460, perceived quality model 482, and sound quality score 440. For instance, leveraging information in perceived quality model 482 that relates one or more objective measurements 460 to sound quality score 440, tuning action recommendation system 472 can determine a recommended action involving a change in one or more parameters 254 or a change in one or more objective measurements 460 to (potentially) cause sound quality score 440 to increase, improve, or move in a particular direction. Details relating to tuning action recommendation system 472 are described further with FIG. 9.

### Selecting and extracting objective measurements that would accurately predict sound quality scores

Accurate prediction of sound quality scores relies on using the right set of objective measurements that are predictive, e.g., has a strong correlation with the sound quality score. It is not trivial to identify and select the right set of objective measurements.

Some models that aim to predict sound quality score lack certain objective measurements that can capture the different behaviors across a wide range of audio systems. In particular, those models use spatial averages in the objective measurements, which do not adequately capture characteristics of audio systems that may have atypical directivities. To address this, one of the objective measurements used in the predictive model advantageously includes a spatial variance or variation measurement. To further illustrate, FIGS. 5-6 contrast two audio systems with different directivities.

Horizontal contour response and vertical contour response refer to how the audio system's sound output varies at different angles in the horizontal and vertical planes, respectively. These responses can be used to understand how sound is distributed throughout a room. The horizontal contour response shows how the speaker's frequency response changes at different angles horizontally. An audio system with a wide uniform horizontal contour response will maintain consistent sound quality across a broad range of angles. The vertical contour response shows how the speaker's frequency response changes at different angles vertically. An audio system with a wide uniform vertical contour response will maintain consistent sound quality at different heights.

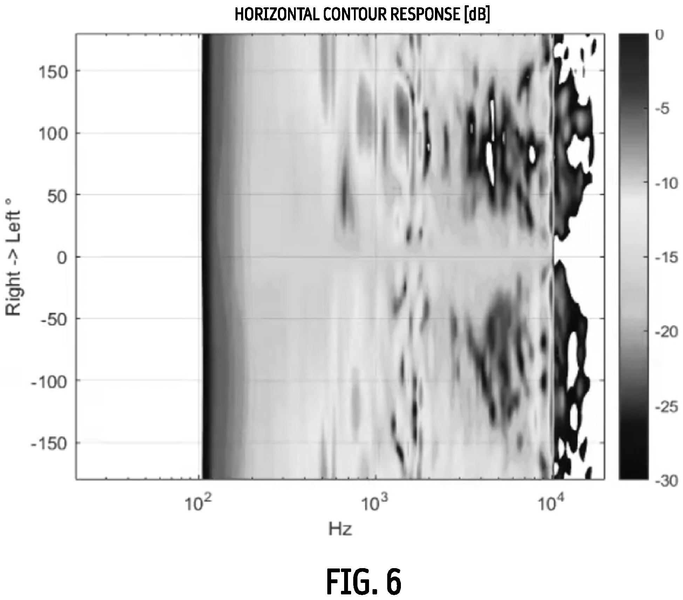

FIG. 5 illustrates an exemplary horizontal contour response of an external audio system, according to some embodiments of the disclosure. The external audio system can be a generally forward firing speaker that can be placed on an entertainment center, a speaker stand, or a floor. It can be seen from the horizontal contour response that the sound field (e.g., measured by SPL) from -50 degrees to +50 degrees is generally uniform and constant, and does not have a lot of point-to-point variability across frequency and space. FIG. 6 illustrates an exemplary horizontal contour response of an integrated audio system, according to some embodiments of the disclosure. The integrated audio system can be a speaker that is on the back of a television and downward firing. The integrated audio system can be equalized to the same flat target as the external audio system related to FIG. 5. It can be seen from the horizontal contour response that the sound field has significant point-to-point variability across frequency and space.

In addition, those models ignore non-linearities in the objective measurements. The blind listening tests revealed that perceived sound quality score can vary substantially as volume changes depending on how non-linear the audio system is. When the audio system reaches a certain output level, an end user will start to perceive the non-linearities present in the system. For this reason, one or more objective measurements used in the predictive model can include one or more non-linearity measurements in the audio system.

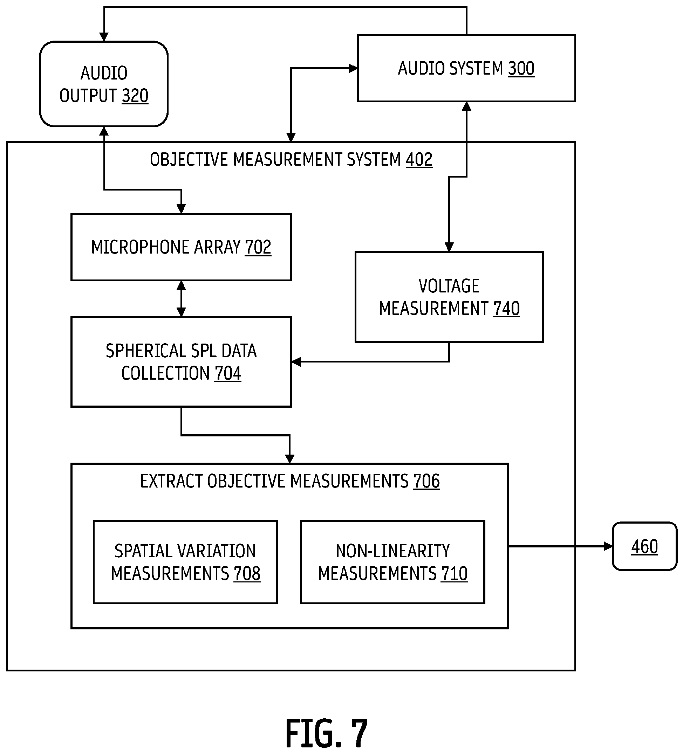

FIG. 7 illustrates objective measurement system 402, according to some embodiments of the disclosure. Objective measurement system 402 includes one or more sensors to sense an audio output of an audio system. For example, objective measurement system 402 may include microphone array 702 having a plurality of microphones. In some cases, a single microphone is used as opposed to an array of microphones. Microphone array 702 can capture and produce audio signals at the individual microphones. Microphone array 702 can capture and produce a combined audio signal based on the individual audio signals at the individual microphones.

Objective measurement system 402 can command audio system 300 to play a chirp (e.g., a sweep signal with increasing frequency). Objective measurement system 402 can command audio system 300 to output a single tone signal (e.g., a sinewave at a certain frequency). Objective measurement system 402 can command audio system 300 to output a multi-tone signal (e.g., multiple sinewaves at different frequencies). In one example, the multi-tone signal can include a 60 Hz tone and a 7 kHz tone with an amplitude ratio of 4:1 (12 decibels). In some embodiments, objective measurement system 402 can command audio system 300 to output a 997 Hz pilot tone. If audio system 300 is a tweeter, objective measurement system 402 may command audio system 300 to output a pilot tone that is higher than 997 Hz. Preferably, the pilot tone has a prime number frequency to avoid harmonics and intermodulation components landing in the same frequency bins as the pilot tone. With the pilot tone active at a certain/fixed amplitude, objective measurement system 402 can command audio system 300 to output a test tone (or a fundamental) and vary the frequency and amplitude of the test tone (e.g., a stepped sinewave). In scenarios where audio system 300 can be very noisy, for low frequencies where the acoustic output (e.g., the test tone or fundamental) is below the noise floor, the pilot tone can show compression (e.g., shoulders or spreading around the test tone or fundamental, raised noise floor) and intermodulation components related to the non-linearity of the system. In particular, harmonic distortion spikes would be detectable on the audio output spectrum between the test tone and the pilot tone, and intermodulation components can appear on the two sides of the pilot tone, even when audio system 300 is noisy. This measurement technique can advantageously reveal non-linearities of a noisy audio system 300. In some embodiments, the pilot tone frequency can be selected to be coprime or mutually prime with the test tone frequency (to ensure that test tone frequency is not an integer multiple of the pilot tone frequency). Audio output 320 generated by audio system 300 can be sensed by microphone array 702. Objective measurement system 402 may command microphone array 702 to record signals when audio system 300 is generating audio output 320.

Objective measurement system 402 includes spherical SPL data collection 704. Spherical SPL data collection 704 may acquire a spherical sound pressure level measurement of audio system 300, e.g., using signals generated by microphone array 702. Spherical SPL data collection 704 can capture audio signals at equal distances around audio system 300, e.g., at different points of a spherical surface, and at regular angular intervals.

In particular, the spherical SPL measurement may include SPL measurements across frequency at a point on the spherical surface. The spherical SPL measurements can yield information such as overall sound radiation pattern, frequency response at different angles, sound power calculations, and directivity characteristics.

In some cases, the spherical SPL measurement may include a maximum SPL measurement at the point on the spherical surface, which can determine the amount of headroom audio system 300 has at different frequencies at the point on the spherical surface.

In some cases, spherical SPL data collection 704 may move microphone array 702 to multiple points on an imaginary sphere surrounding audio system 300, creating a three-dimensional map of how sound radiates in different directions. Spherical SPL data collection 704 can move microphone array 702 to make SPL measurements on a spherical surface. Spherical SPL data collection 704 can rotate audio system 300 to allow microphone array 702 to make SPL measurements on a spherical surface. Spherical SPL data collection 704 can rotate the audio system 300 to allow microphone array 702 to make SPL measurements on a spherical surface. Rotating audio system 300 can include utilizing two turntables which are able to rotate audio system 300 along the vertical and horizontal axes. Less space is needed while spherical SPL measurements can still be captured using a (stationary) microphone array 702.

In some cases, objective measurement system 402 may include voltage measurement 740. Voltage measurement 740 can acquire a voltage measurement of a speaker clamp in audio system 300, e.g., voltage across frequency. The voltage measurement may include a voltage measurement of the voltage output of the speaker clamp. The voltage measurement can be used to normalize SPL measurement and account for undesirable time-shifting produced by the amplifiers in audio system 300. The spherical SPL measurement can be divided by the voltage measurement. Accounting for the voltage sensitivity allows the spherical SPL measurement to be independent of input power and removes amplifier influence from the SPL measurements.

Objective measurement system 402 includes extract objective measurements 706, which can take the spherical SPL measurements (and optionally the SPL measurements divided by the voltage measurement), and perform analysis on the spherical SPL measurements. From the spherical SPL measurements, extract objective measurements 706 can extract one or more objective measurements 460.

Objective information that can be determined by extract objective measurements 706 can include one or more of: directivity patterns (measuring how sound pressure varies with angle and frequency, showing sound radiation strength in different directions, normalized to the average level across all angles), frequency response (quantifying how output pressure relates to input signal across frequencies at each measurement point, showing the system's transfer function), coverage uniformity (calculates statistical deviation of SPL across measurement points at each frequency, indicating consistency of sound distribution), off-axis response (comparing frequency response at various angles to the on-axis (direct front) response, revealing timbral changes with position), on-axis response (frequency response measured directly in front of audio system 300), total acoustic power (integrating sound intensity over the entire measurement sphere, accounting for directivity to determine total sound energy output), polar patterns or contours (revealing SPL variation with angle at specific frequencies, plotted as circular diagrams for horizontal or vertical planes, such as horizontal/vertical contour responses), front-to-back ratio (measuring the level difference between front and rear radiation, indicating directionality at each frequency), beamwidth (measuring the angular spread where SPL drops a number of decibels from maximum, showing coverage angle at each frequency), and phase response (tracking timing/phase differences across measurement points, revealing spatial coherence and potential interference patterns).

In some cases, objective measurements 706 includes spatial variation measurements 708 to extract one or more spatial variance measurements from the spherical SPL measurements. A spatial variance measurement can quantify variations of SPL across frequency and space. The following code illustrates extracting a spatial variance measurement from the spherical SPL measurements:

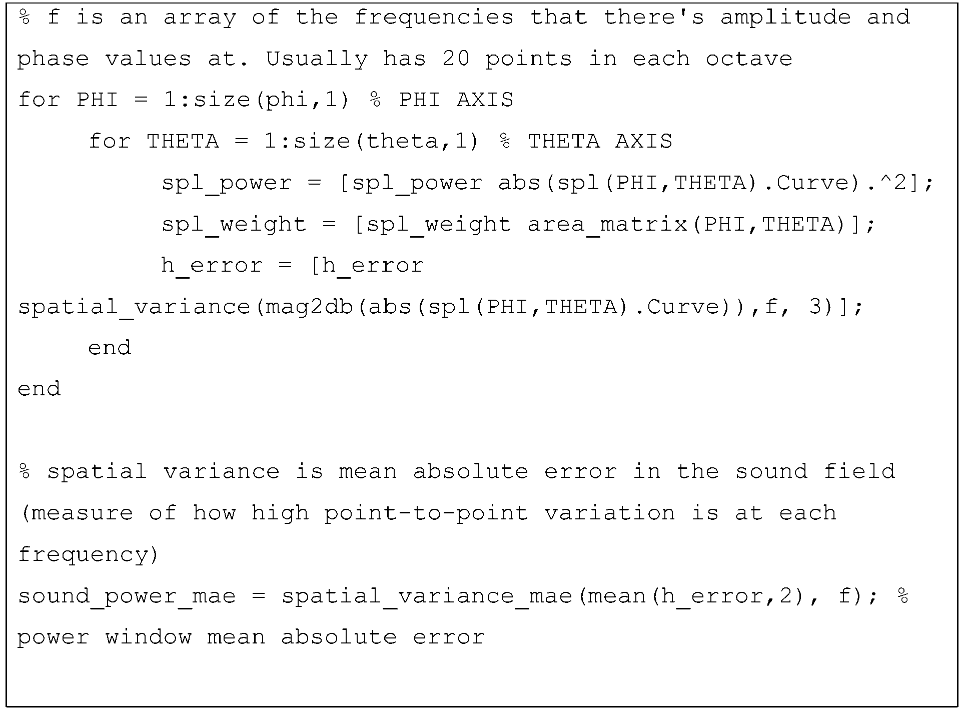

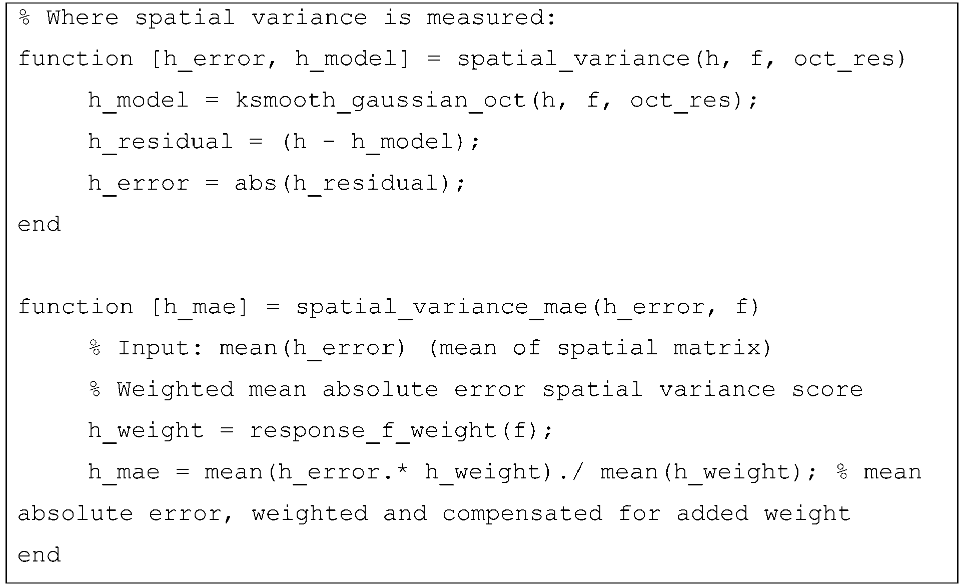

In some embodiments, spatial variation measurements 708 may extract a spatial variance measurement quantifying how much the SPL deviates from an idealized SPL (e.g., a smoothed curve, represented as h_model above) across phi and theta. Within the nested for loops above, the spatial variance measurement using the function spatial_variance(h,f,oct_res) is calculated for combinations of phi and theta. Phi and theta are angles that define a point's position in 3D space along with a radius r. Theta is the azimuthal angle in the x-y plane from the x-asix. Phi is the polar or zenith angle from the positive z-axis (or in some cases measured from the x-y plane). A point (x, y, z) in the SPL measurements can be specified using phi and theta (along with radius) as follows: x=r*sin(phi)*cos(theta), y=r*sin(phi)*sin(theta), and z=r*cos(theta). Spatial variation measurements 708 can use the function spatial_variance(h,f,oct_res) to calculate the spatial variance measurement at a given phi and theta. Specifically, the function takes three inputs: h, f, and oct_res. The input h represents a particular SPL measurement (e.g., a frequency response curve at a given phi and theta, such as mag2db(abs(spl(phi,theta).Curve))).spl(phi,theta). Curve represents a curve property of the SPL data at a given phi and theta. abs(spl(phi.theta).Curve)) takes the absolute value of the curve data. mag2db(abs(spl(phi,theta).Curve))) converts the magnitude values to decibels. The input f represents a frequency value (or an array of frequency values). The input oct_res represents the octave resolution (e.g., 3). The function returns two outputs: h_error and h_model. The output h_model creates the idealized smooth curve using the function, ksmooth_gaussian_oct(h, f, oct_res) according to the inputs h, f, and oct_res. The idealized smooth curve (h_model) is created using Gaussian smoothing. A residual, h_residual is calculated as a difference between the idealized smooth curve h_model and the input h (representing an SPL measurement, or a frequency response curve at a given phi and theta). The output, h_error representing the error or quantifying the magnitude of the deviation from the ideal smooth curve, is the absolute value of h_residual.

In some embodiments, spatial variation measurements 708 may extract a direct sound balance measurement as an objective measurement. Time windowing can isolate direct sound. In one example, direct sound balance can be calculated based on a ratio of on-axis SPL and an average SPL of the direct sound component over all measurement points on the sphere, at different frequencies. Phrased differently, a frequency response of direct sound can be extracted by analyzing the SPL of direct sound at different frequencies. In some embodiments, direct sound balance measurement or direct balance measurement quantifies or characterizes a mean frequency response over a listening window (e.g., an area where the listener is expected to be sitting), In particular, direct sound balance measurement or direct balance measurement may quantify how large the errors are in the mean frequency response relative to an expected frequency response (e.g., a flat response). Direct sound balance measurement or direct balance measurement may quantify the flatness of the listening response for direct sound received by a listener.

In some embodiments, spatial variation measurements 708 may extract a direct sound quality measurement as an objective measurement. The direct sound quality measurement can quantify a flatness or an amount of errors in a frequency response of direct sound. The frequency response of direct sound can be extracted from the spherical SPL measurements and compared against a flat or target frequency response to quantify the flatness or an amount of errors. In one example, smoothness/roughness quantifying the rate of change can be extracted from the frequency response of direct sound. In another example, variance or statistical variance can be extracted from the frequency response of direct sound. In some embodiments, direct sound quality measurement or direct quality measurement quantifies or characterizes how much the sound field varies between different angles in the listening window. In particular, direct sound quality measurement or direct quality measurement may quantify spatial variance in the listening window. Direct sound quality measurement or direct quality measurement may quantify how much the listener's experience is changing when moving. Direct sound quality measurement or direct quality measurement may quantify how different the sound is between ears. Direct sound quality measurement or direct quality measurement may quantify how different the indirect sound is compared to a flat response.

In some embodiments, spatial variation measurements 708 may extract a power balance measurement over both direct sound and indirect sound as an objective measurement. In one example, power balance can be calculated based on calculated based on a ratio of on-axis SPL and an average SPL of both direct and indirect sound over all measurement points on the sphere, at different frequencies. Phrased differently, a frequency response of both direct and indirect sound can be extracted by analyzing the SPL of both direct and indirect sound at different frequencies. In some embodiments, power balance measurement quantifies or characterizes a mean frequency response over all audio radiated out by the audio system in all directions. In particular, power balance measurement quantifies how large the errors are in the mean frequency response relative to an expected frequency response (e.g., a flat response). Power balance measurement can quantify the flatness of the listening response for the indirect sound received by a listener.

In some embodiments, spatial variation measurements 708 may extract a power quality measurement as an objective measurement. The direct sound quality measurement can quantify a flatness or an amount of errors in a frequency response of both direct sound and indirect sound. The frequency response of both direct sound and indirect sound can be extracted from the spherical SPL measurements and compared against a flat or target frequency response to quantify the flatness or an amount of errors. In one example, smoothness/roughness quantifying the rate of change can be extracted from the frequency response of both direct sound and indirect sound. In another example, variance or statistical variance can be extracted from the frequency response of both direct sound and indirect sound. In some embodiments, power quality measurement quantifies or characterizes how much the sound field varies between different angles all around the audio system. Power quality measurement may quantify how much the listener's experience changes when moving. Power quality measurement may quantify how different indirect sound is compared to direct sound.

In some embodiments, spatial variation measurements 708 may extract a forward directivity measurement as an objective measurement. The forward directivity measurement can quantify a frequency-dependent ratio between direct sound and indirect sound. The forward directivity measurement can indicate how much of the sound, and at which frequencies, is sent directly forward. Time windowing can isolate direct sound and indirect sound. The frequency response of direct sound and the frequency response of indirect sound can be extracted from the spherical SPL measurements. The frequency-dependent ratio can be extracted from comparing the frequency response of direct sound and the frequency response of indirect sound.

In some embodiments, spatial variation measurements 708 may extract a directivity indexed balance measurement. The directivity indexed balance measurement may quantify or characterize how flat the difference is between direct and indirect sound.

In some embodiments, spatial variation measurements 708 may extract a directivity indexed quality measurement. The directivity indexed quality measurement may quantify or characterize the mean absolute error of the response at different angles compared to the mean sound power over all angles.

In some embodiments, spatial variation measurements 708 may extract a directivity index measurement. The directivity index measurement may quantify or characterize the relative level of direct to indirect sound received by the listener. A negative directivity index means the listener would hear more indirect sound than direct sound.

In some cases, objective measurements 706 includes non-linearity measurements 710 to extract one or more non-linearity measurements from the spherical SPL measurements. Non-linearity measurements can quantify the perceived distortion that could be present in audio output 320 produced by audio system 300. Examples of non-linearity measurements can include low frequency extension measurements (e.g., how much bass audio system 300 can play and at what volume), intermodulation scores, harmonic distortion scores, etc.

In some embodiments, non-linearity measurements 710 can extract an intermodulation distortion score. When audio system 300 is outputting a multi-tone signal (e.g., two sinewaves, where the lower frequency sinewave may have a higher amplitude than the higher frequency sinewave), non-linearity measurements 710 examines the frequency spectrum of audio output 320 as captured by microphone array 702 and extracts the original tones (at f1 and f2), and the intermodulation products (at f2+f1, f2-f1, etc.). The intermodulation distortion score can be calculated based on the square root of the ratio between the sum of power of intermodulation products and the sum of power of the original frequencies times 100. Non-linearities in audio system 300 would exhibit as intermodulation products.

In some embodiments, one or more non-linearity scores can be extracted by non-linearity measurements 710 from one or more plots of the max SPL measurements over frequency at one or more levels of a fundamental tone. The plot may have a data point for the fundamental, which is the frequency at which the audio system is being tested. The level of the fundamental can be increased in steps by non-linearity measurements 710 to identify one or more non-linearity parameters at different levels of the fundamental. The plot may have a data point for the pilot, which is a secondary tone playing at a higher frequency where the signal to noise ratio and system output is much better to help with the quality of the measurement. The pilot tone cam be kept at the same level throughout the test as a reference signal. An intermodulation distortion score can be measured based on the relative level of the intermodulation components caused by non-linearities of the audio system while both tones are played. The level of the fundamental and the level of the pilot tone can be measured to compare actual fundamental gain to expected gain. Compression measurements can be measured by assessing whether the pilot tone's actual level changes when the level of the fundamental changes. Temperature-related measurements can be measured by assessing whether the pilot tone's actual level changes at initial conditions versus at later conditions when temperature is higher or different from initial conditions.

In some embodiments, non-linearity measurements 710 can extract a volume displacement measurement quantifying how loud audio system 300 can produce an audio output and maintain a level of performance. Because volume displacement is directly related to the spherical SPL measurements, volume displacement measurement can be derived from the spherical SPL measurements and capture the largest volume displacement audio system 300 can have (e.g., maximum SPL generated) without significant distortion.

In some embodiments, non-linearity measurements 710 can extract a low frequency extension measurement quantifying a lowest frequency audio system 300 can produce an audio output. The low frequency extension measurement can quantify the lowest frequency audio system 300 can play.

In some embodiments, non-linearity measurements 710 can extract a base cutoff measurement quantifying a weighted high-pass cutoff frequency at a starting volume. A lower base cutoff measurement can be correlated with better perceived sound quality.

In some embodiments, non-linearity measurements 710 can extract a cutoff change slope measurement quantifying how the weighted high-pass cutoff frequency changes when the level increases. The cutoff change slope measurement can be determined based on first and second order polynomial coefficients of a polynomial that relates the weighted high-pass cutoff frequency and the level. A smaller cutoff change slope or less change in the weighted high-pass cutoff frequency change when the level changes can be correlated with better perceived sound quality.

In some embodiments, non-linearity measurements 710 can extract a maximum cutoff measurement quantifying a weighted high-pass cutoff frequency at a highest level the audio system can safely play.

In some embodiments, non-linearity measurements 710 can extract a start cutoff level measurement quantifying an actual SPL level played at the starting volume at a determined cutoff frequency. A higher start cutoff level measurement can be correlated with better perceived sound quality.

In some embodiments, non-linearity measurements 710 can extract a cutoff level change slope measurement quantifying how the weighted high-pass cutoff level changes when level increases or changes. The cutoff level change slope measurement can be determined based on first and second order polynomial coefficients of a polynomial that relates the weighted high-pass cutoff level and the level. In an audio system with little to no non-linearity, compression, or distortion, the cutoff level change slope measurement is around 1dB per change in 1 dB in the level/volume.

In some embodiments, non-linearity measurements 710 can extract a base total intermodulation distortion measurement based on a ratio of the energy in the fundamental to energy in the components created by intermodulation distortion, at a starting level or volume.

In some embodiments, non-linearity measurements 710 can extract a total intermodulation distortion change slope measurement quantifying how the total intermodulation distortion (e.g., a ratio of the energy in the fundamental to energy in the components created by intermodulation distortion) changes as the level increases or changes. The total intermodulation distortion change slope measurement can be determined based on first and second order polynomial coefficients of a polynomial that relates total intermodulation distortion to level/volume.

In some embodiments, non-linearity measurements 710 can extract a peak total intermodulation distortion measurement based on a total intermodulation distortion (e.g., a ratio of the energy in the fundamental to energy in the components created by intermodulation distortion) at a highest level that the audio system can safely play.

In some embodiments, non-linearity measurements 710 may calculate one or more weighted sums of some of these measurements to generate one or more non-linearity measurements associated with, e.g., cutoff, output level, and intermodulation distortion. Non-linearity measurements 710 may calculate a cutoff score or objective measurement based on a weighted sum of one or more of: a base cutoff measurement, a cutoff change slope measurement, and a maximum cutoff measurement. In some embodiments, non-linearity measurements 710 may calculate an output level score based on a weighted sum of one or more of: a start cutoff level measurement, and a cutoff level change slope measurement. In some embodiments, non-linearity measurements 710 may calculate an intermodulation distortion score based on a weighted sum of one or more of: a base total intermodulation distortion measurement, a total intermodulation distortion change slope measurement, and a peak total intermodulation distortion measurement.

In some embodiments, non-linearity measurements 710 may extract one or more measurements that quantify or characterize the limits of the audio system. Because non-linearity measurements 710 may be extracting one or more measurements of audio systems that can be very non-linear and noisy, non-linearity measurements 710 may try to fit a fourth, second or first order high-pass model that best describes an unknown audio system and determine which kind of model best fits the power averaged response of the audio system. A first order high-pass filter transfer function may be defined as: H(s) = s/(s + (ω₀). A second order high-pass filter transfer function may be defined as: H(s) = s²/(s² + (ω₀/Q)s + ω₀²). A fourth order high-pass filter transfer function may include cascaded second order high-pass filters, and the transfer function may be a product of multiple second order high-pass filter transfer functions. A model which results in the lowest error (e.g., least squares error, root mean squared error, etc.) is considered the best fitted model. Non-linearity measurements 710 may use a (best) fitted model to find the true hardware limits of the audio system, and/or the equivalent for a combined audio system and digital signal processing system. Using the (best) fitted model is beneficial for cleaning up the power averaged response curve and enable cutoff-related measurements to be extracted more easily without being significantly impacted by the noise and non-linearities of the audio system. The kind of model (e.g., a first order, second order, or a fourth order high-pass model) can also help identify whether the audio system is a ported system (best modeled as a fourth order high-pass model, a bass reflex or vented system) or an unported system (best modeled as a second order high-pass model, a sealed, acoustic suspension, or closed box system).

In some embodiments, non-linearity measurements 710 can extract a ported versus non-ported measurement based on the type of high-pass model that best fits the power averaged response of the audio system. A second order high-pass model can indicate that the audio system is an unported system. A fourth order high-pass model can indicate that the audio system is a ported system. Different types of audio systems (ported or unported) can be correlated with differences in perceived sound quality.

In some embodiments, non-linearity measurements 710 may implement one or more procedures illustrated in the pseudocode below to extract one or more non-linear measurements:

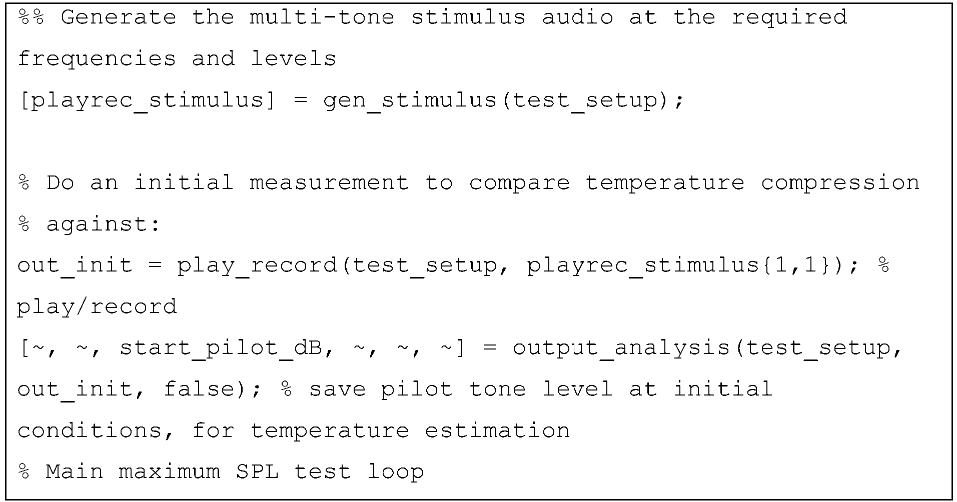

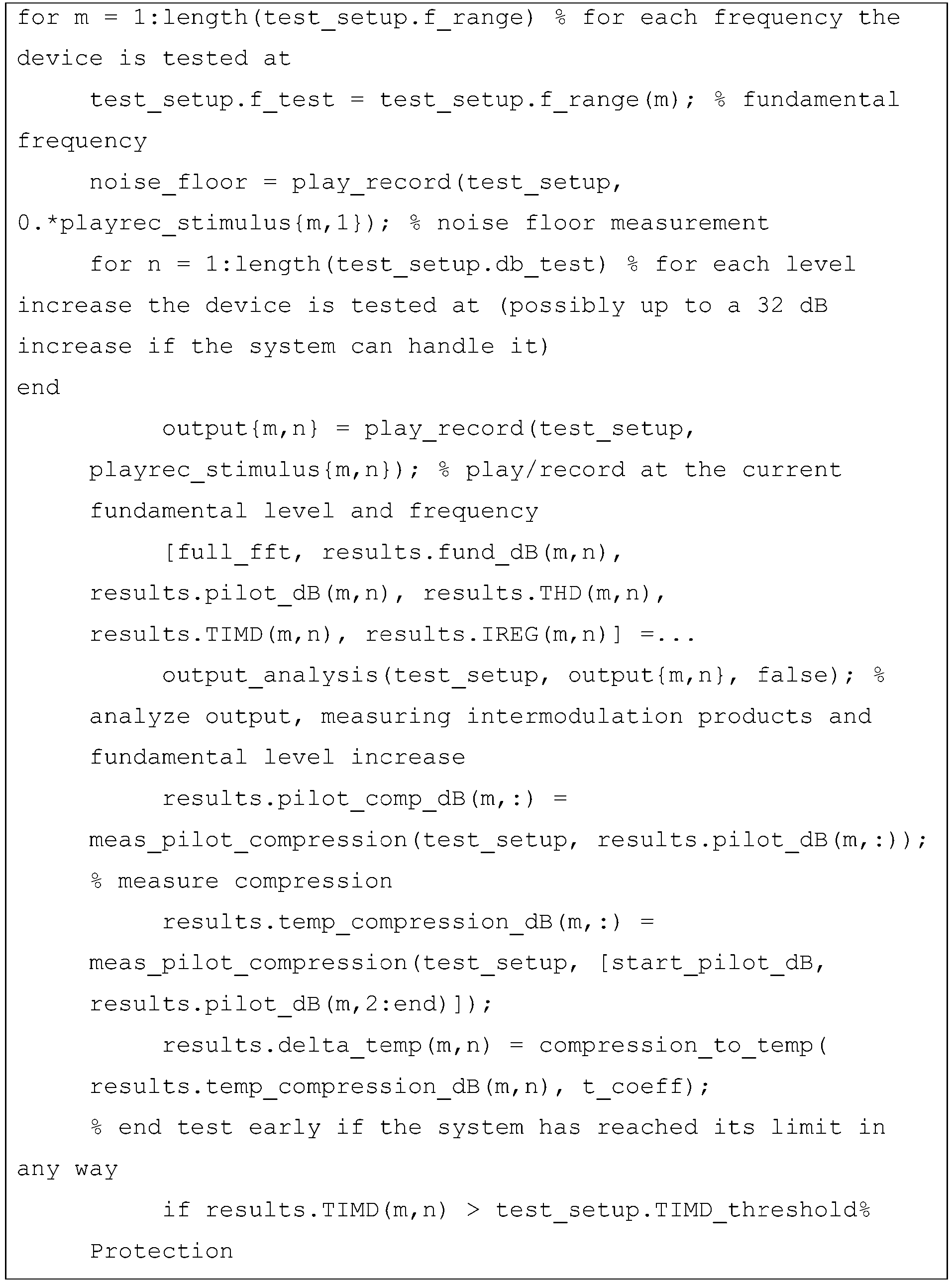

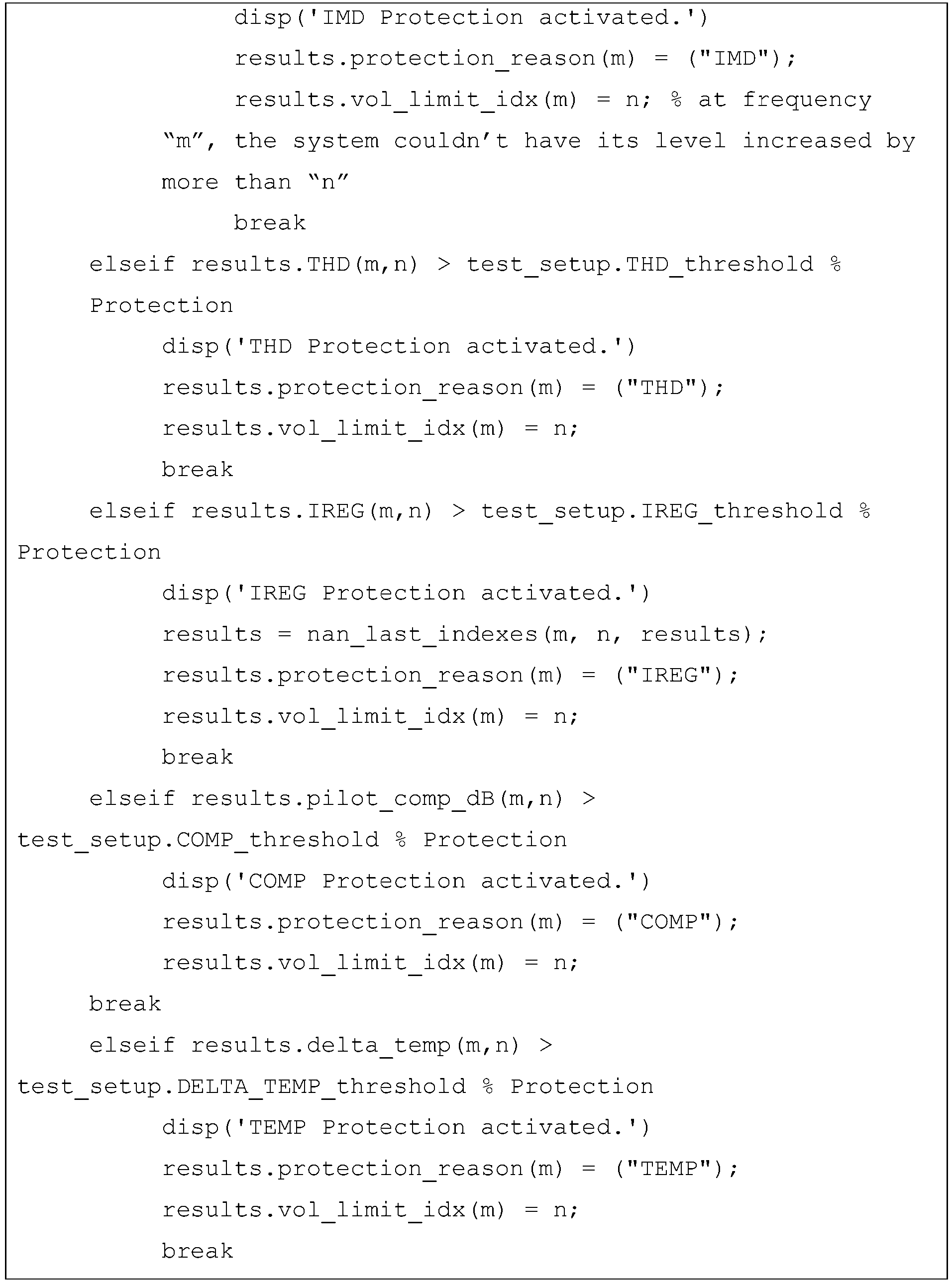

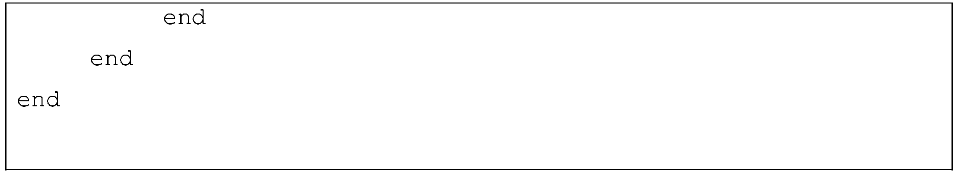

In some embodiments, non-linearity measurements 710 may implement procedures to make maximum SPL measurements across frequency and at different levels of the fundamental tone. Non-linearity measurements 710 may produce a plot of maximum SPL over frequency for each level of the fundamental. Based on the plots of maximum SPL over frequency one or more non-linearity measurements can be extracted.

Objective measurement system 402, such as extract objective measurements 706, extract one or more objective measurements 460 (e.g., a set of values for a set of input variables) which are important for predicting perceived sound quality for a wide range of audio systems. In particular, when the objective measurements are used as input to the predictive model, the predictive model can achieve high accuracy for predicting the perceived sound quality score for a wide range of audio system. One or more objective measurements 460 may include one or more measurements made by extract objective measurements 706, a derivation thereof, or a combination thereof.

### Designing and training the perceived quality model

FIG. 8 illustrates perceived quality model 482, according to some embodiments of the disclosure. Perceived quality model 482 can receive one or more objective measurements 460 and output sound quality score 440. Perceived quality model 482 is trained using training data 444, so that model parameters of perceived quality model 482 can be determined based on training data 444. The training technique can differ depending on the implementation of the underlying model in perceived quality model 482. The objective of perceived quality model 482 is to transform one or more objective measurements 460 into a predicted perceived sound quality score 440.

In some cases, perceived quality model 482 may include multiple models implemented with different model architectures to produce respective predicted scores. The predicted scores from the models can be combined (e.g., using a voting method or a weighted voting method) to produce a (final) sound quality score 440.

In some cases, perceived quality model 482 may include multiple models implemented to receive and process different subsets of one or more objective measurements 460 and produce respective predicted scores. The predicted scores from the models can be combined (e.g., using summing method, an averaging method, or a weighted average method) to produce a (final) sound quality score 440.

In some embodiments, perceived quality model 482 can include multivariate linear regression model 802, which relates one or more objective measurements 460 (as independent variables) and sound quality score 440 (as a dependent variable). Multivariate linear regression model 802 can be expressed as: $Q = {β}_{0} + {β}_{1} ∗ {X}_{1} + {β}_{2} ∗ {X}_{2} + ⋯ + + {β}_{k} ∗ {X}_{k} + ϵ$

Q is sound quality score 440. X₁, ... Xₖ are the one or more objective measurements 460. *β*₀ is the intercept. *β*₁, ... *βₖ* are the coefficients for one or more objective measurements 460. *ε* is an error term. *β*₀*,* ... *βₖ* and *ε* are the parameters of the multivariate linear regression model. Training multivariate linear regression model 802 (e.g., determining the parameters) using training data 444 can involve estimating the parameters that minimize the difference between the predicted values and the actual values of the sound quality score Q. Training can use ordinary least square method (or similar) to minimize the sum of the squared residuals (e.g., the difference between the predicted values and the actual values).

In some embodiments, perceived quality model 482 can include regularized linear regression models that add a penalty term to the loss function to prevent overfitting. One example is Lasso regression, which uses L1 regularization. Another example is Ridge regression which uses L2 regularization. Another example is elastic net, which is a combination of Lasso regression and Ridge regression.

In some embodiments, perceived quality model 482 can include machine learning model 804, which relates one or more objective measurements 460 (as one or more inputs to the machine learning model) and sound quality score 440 (as a predicted output of the machine learning model). In one example, machine learning model 804 can include a random forest regression model that constructs multiple decision trees during training using training data 444 and outputs an average prediction of the individual decision trees. In one example, machine learning model 804 can include a gradient boosting machine that constructs serial decision trees during training using training data 444 and uses each decision tree to correct the error of a previous decision tree. In one example, machine learning model 804 can include a support vector regression (an extension of support vector machines) to fit a best line within a threshold value. In one example, machine learning model 804 can include a neural network, such as a multi-layer perceptron model, whose parameters of the neurons in the neural network can be trained using training data 444 using gradient descent.

### Offering feedback to improve the audio system

FIG. 9 illustrates tuning action recommendation system 472, according to some embodiments of the disclosure. Tuning action recommendation system 472 includes optimize score 930. The objective of optimize score 930 is to determine one or more parameters 254 that can improve the output of perceived quality model 482 (e.g., the predicted perceived sound quality score). The scores produced by perceived quality model 482 can be evaluated by tuning action recommendation system 472 to assess which values for one or more parameters 254 can yield the best score. Determining one or more parameters 254 that can improve the output of perceived quality model 482 can involve determining one or more parameters 254 that would result in objective measurements that could yield a better output of perceived quality model 482.

Optimize score 930 can implement a search algorithm to try out different sets of one or more parameters 254 and determine values for one or more parameters 254 that would optimize an objective function. The objective function is based on perceived quality model 482, which can objectively predict the sound quality score based on the one or more objective measurements. Optimize score 930 can solve an optimization problem by finding optimal values for one or more parameters 254 from possible values for one or more parameters 254, using perceived quality model 482 as the objective function. The possible values for one or more parameters 254 can be constrained by acceptable/allowable ranges of values for one or more parameters 254. As opposed to manual tuning with "golden ears", optimize score 930 can systematically, computationally, and programmatically determine optimal values for one or more parameters 254 using a data driven and objective perceived quality model 482, and know when optimal values have been achieved (e.g., at convergence).

Illustrative examples for one or more parameters 254 or other parameters which may impact quality of audio output are described with FIG. 3. One or more parameters 254 generated by tuning action recommendation system 472 can include one or more parameters for one or more audio processing algorithm, such as one or more audio processing algorithms implemented on an audio DSP.

Tuning action recommendation system 472 can determine one or more first objective measurements of an audio system having one or more first parameters applied thereto. The one or more first objective measurements are input into perceived quality model 482 to obtain a first sound quality score. Tuning action recommendation system 472 can determine one or more second objective measurements of the audio system having one or more second parameters applied thereto. The one or more second objective measurements are input into perceived quality model 482 to obtain a second sound quality score. Optimize score 930 can determine one or more optimal parameters for the audio system based on the first sound quality score and the second sound quality score. In some cases, optimize score 930 can determine one or more third parameters based on a direction of change in the first sound quality score and the second sound quality score (e.g., implementing gradient descent based on the change in the sound quality score or a gradient of the sound quality score).

In some scenarios, the audio system is available and accessible to produce different audio outputs. Optimize score 930 can iteratively produce different sets of values for one or more parameters 254 and apply the different sets to the audio system so that the audio system can generate different outputs from which different objective measurements can be extracted. In some embodiments, the objective measurements can be extracted from spherical SPL measurements made on the outputs generated by the audio system. The different objective measurements can be used as an input to perceived quality model 482 to produce different sound quality scores. A set of values of one or more parameters 254 that resulted in the best sound quality score can be used as the optimal values for one or more parameters 254.

In some scenarios, the audio system is not available and accessible to produce different audio outputs. Optimize score 930 can iteratively produce different sets of values for one or more parameters 254 and apply the different sets to a model of an audio system, depicted as audio system model 902, that is parameterizable so that the model of the audio system can generate different outputs from which different modeled objective measurements 920 can be extracted, or so that the model of the audio system can generate different modeled objective measurements 920. The different modeled objective measurements 920 can be used as an input to perceived quality model 482 to produce different sound quality scores. A set of values of one or more parameters 254 that resulted in the best sound quality score can be used as the optimal values for one or more parameters 254. It is conceivable that audio system model 902 may not exactly simulate or replicate the actual audio system, but audio system model 902 can effectively model how different values of one or more parameters 254 may result in different values for modeled objective measurements 920.

In some embodiments, tuning action recommendation system 472 may determine one or more recommended actions based on one or more of: the one or more first objective measurements, the one or more second objective measurements, the predictive model, the first sound quality score, and the second sound quality score.

In some embodiments, tuning action recommendation system 472 may pass feedback to a manufacturer/designer of the audio system, and the feedback may include one or more of: the one or more first objective measurements, the one or more second objective measurements, the first sound quality score, and the second sound quality score.

In some embodiments, tuning action recommendation system 472 may retrieve a recommended action from a database of solutions using one or more of: the one or more first objective measurements, the one or more second objective measurements, the first sound quality score, and the second sound quality score.

In some embodiments, tuning action recommendation system 472 may produce a recommended action based on parameters of the predictive model (e.g., perceived quality model 482), which can relate the objective measurements to the sound quality score. The parameters of the predictive model can indicate different correlations. Based on the correlations, tuning action recommendation system 472 can determine a recommendation action specifying a change/adjustment in an objective measurement based on the correlations that can result in an improved sound quality score. In some cases, based on the correlations, tuning action recommendation system 472 can determine a recommendation action specifying a change/adjustment in one or more parameters 254 that would result in the change/adjustment in the objective measurement based on the correlations that can result in an improved sound quality score.

In some embodiments, tuning action recommendation system 472 may produce feedback to a manufacturer/designer of the audio system based on a change between the first sound quality score and the second sound quality score. The feedback can specify that a change between the one or more first objective measurements and the one or more second objective measurements resulted in a change in the predicted score (e.g., in a specific direction).

In some embodiments, tuning action recommendation system 472 may produce feedback to a manufacturer/designer of the audio system in response to detecting that the predicted sound quality score is below a threshold or qualifies as poor. In some cases, the feedback can specify which one of the objective measurements to change (e.g., based on parameters of perceived quality model 482) to improve the predicted sound quality score.

In some embodiments, tuning action recommendation system 472 may initially evaluate possible values for one or more parameters 254 that can optimize one or more linear processes of the physical audio system and/or audio system model 902. For example, tuning action recommendation system 472 may evaluate values for one or more parameters 254 that impact or change one or more spatial variation measurements (e.g., measurements made by spatial variation measurements 708 of FIG. 7). Tuning action recommendation system 472 may determine values for one or more parameters 254 that can flatten or improve one or more of direct balance measurement, direct quality measurement, power balance, power quality, directivity indexed balance, directivity indexed quality, and directivity index, which would in turn optimize or improve the sound quality score predicted by perceived quality model 482. Tuning action recommendation system 472 may apply different values for one or more parameters 254 to audio system model 902 in a linear fashion to obtain one or more objective measurements, which can be which can be fed as input to perceived quality model 482 to assess the sound quality score. The values for one or more parameters 254 achieving optimal or improved sound quality score can be used as a starting point for finetuning and evaluating further possible values for one or more parameters 254. Additional values which are around the starting point can be evaluated by tuning action recommendation system 472 to find values that can optimize one or more non-linear processes of the physical audio system and/or audio system model 902. In some cases, those values around the starting point can be applied to the physical audio system and/or audio system model 902 and hard limits of audio system model 902 (e.g., how excursion or temperature changes these limits) can be extracted as objective measurements, which can be fed as input to perceived quality model 482 to assess the sound quality score. Values which can yield the optimal or improve the sound quality score can be selected as the optimal values for one or more parameters 254.

### Tuning as a service system

Referring briefly back to FIG. 4, objective measurement system 402, perceived quality model 482, and tuning action recommendation system 472 can be implemented on a computer system that is local to (or on-premise with) audio system 300. In some scenarios, it would be more scalable to offer the manufacturer/designer of audio system 300 a measurement kit to make spherical SPL measurements as described with FIG. 7, and the spherical SPL measurements can be transmitted to a remote service, referred to as a tuning as a service system. The remote service can produce optimal values for the tunable parameters of the audio system and send the optimal values back to the manufacturer/designer. The remote service can generate feedback and/or recommended actions and pass the feedback and/or recommended actions to the manufacturer/designer.

Separating the measurement process from the prediction and tuning processes can allow the prediction and tuning processes to improve/iterate without impacting the manufacturer/designer or the measurement process. Also, implementing a remote service and sharing the measurement kit to many manufacturer/designers can make the remote service accessible to more manufacturer/designers, thereby making the tuning service more scalable. In addition, deploying the remote service in one centralized location makes the tuning service easier to maintain.

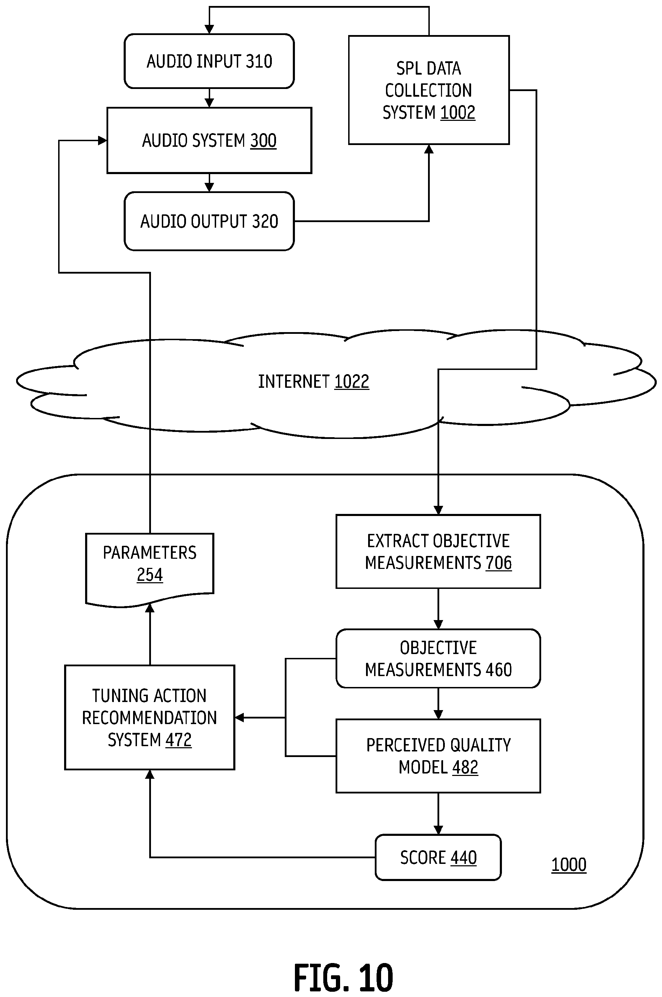

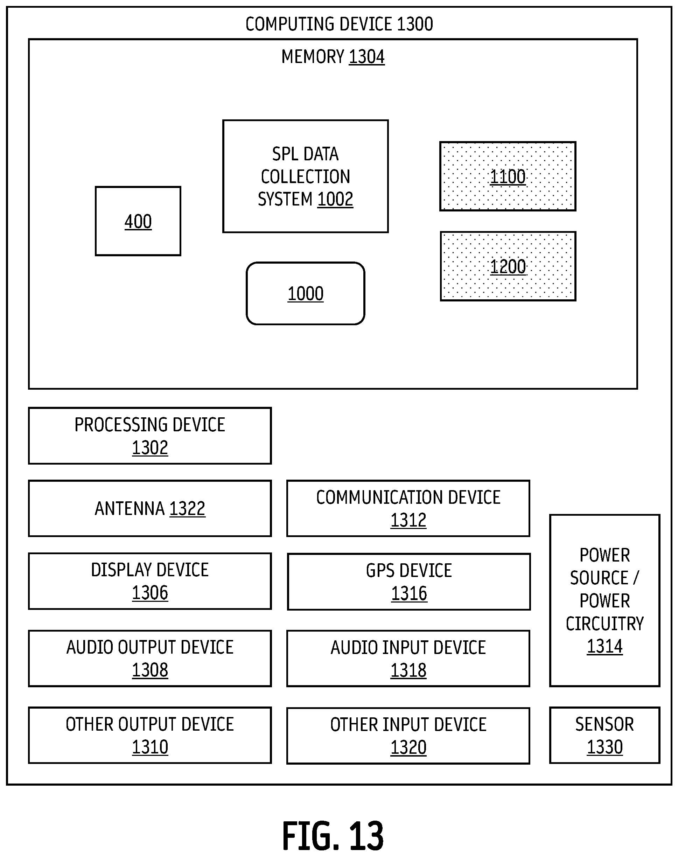

FIG. 10 illustrates tuning as a service system 1000, according to some embodiments of the disclosure. Tuning as a service system 1000 can be implemented remotely from audio system 300. SPL data collection system 1002 can include a measurement kit that includes microphone array 702 and one or more components of spherical SPL data collection 704 as described with FIG. 7. SPL data collection system 1002 can be implemented on a computing device such as computing device 1300 of FIG. 13.

SPL data collection system 1002 can implement a graphical user interface to allow the manufacturer/designer to initiate and monitor the measurement process. SPL data collection system 1002 can include an orchestrator that can trigger audio system 300 using audio input 310 to produce audio output 320. The orchestrator can make physical adjustments to audio system 300 and/or a microphone array as part of the measurement process. The orchestrator can make the spherical SPL measurements based on audio output 320. SPL data collection system 1002 can include a file builder that can record and encode audio files captured at different points of the spherical surface. The audio files may be recorded along with theta and phi to specify a point on the spherical surface, The file builder may record metadata, including one or more of: sphere radius, angular resolution, sample frequency, etc. The file builder may record device metadata including one or more of: device manufacturer, serial number, model number, and screen size. The orchestrator can perform a sequence of measurements to obtain a specified set of spherical SPL measurements. The graphical user interface may notify the manufacturer/designer of the progress and completion of the measurement process. SPL data collection system 1002 can transmit one or more audio files via a network, such as Internet 1022, to tuning as a service system 1000. Tuning as a service system 1000 may include an application programming interface to allow the one or more audio files to be posted to tuning as a service system 1000.

Tuning as a service system 1000 may include one or more workers or microservices implemented on cloud computing infrastructure to perform one or more functionalities associated with extract objective measurements 706, perceived quality model 482, and tuning action recommendation system 472. Extract objective measurements 706 can extract one or more objective measurements from the audio files. One or more objective measurements 460 can be provided as input to perceived quality model 482 to generate sound quality score 440.

In some embodiments, tuning as a service system 1000 may receive one or more system transfer functions that characterize audio system 300, and provide the one or more system transfer functions to audio system 300. Tuning action recommendation system 472 can utilize the one or more system transfer functions (and any other applicable subsystem transfer functions available) to model audio system 300 when determining one or more recommended actions and/or optimal values for one or more parameters 254.

One or more parameters 254 can be provided back to audio system 300 via Internet 1022 as a configuration file. The configuration file can be a plaintext file or a structured human-readable text file, which can be uploaded to or installed on audio system 300 using firmware. The configuration file can include key-value pairs that specify one or more parameters 254 and corresponding optimal values for one or more parameters 254. The configuration file can specify a tuning profile of audio system 300. Examples of key-value pairs can include input gain values, high-pass filter parameters, low-pass filter parameters, one or more parameters 254 as described herein, etc.

### Exemplary methods for predicting a perceived quality score

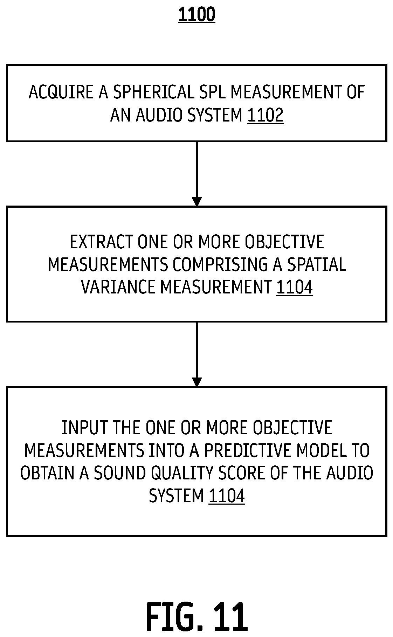

FIG. 11 depicts a flow diagram illustrating method 1100 for predicting a perceived quality score, according to some embodiments of the disclosure.

In 1102, a spherical sound pressure level measurement of an audio system is acquired.

In 1104, one or more objective measurements are extracted from the spherical sound pressure level measurement, the one or more objective measurements comprising a spatial variance measurement.

In 1106, the one or more objective measurements are input into a predictive model to obtain a sound quality score of the audio system.

### Exemplary methods for optimizing the perceived quality score through tuning

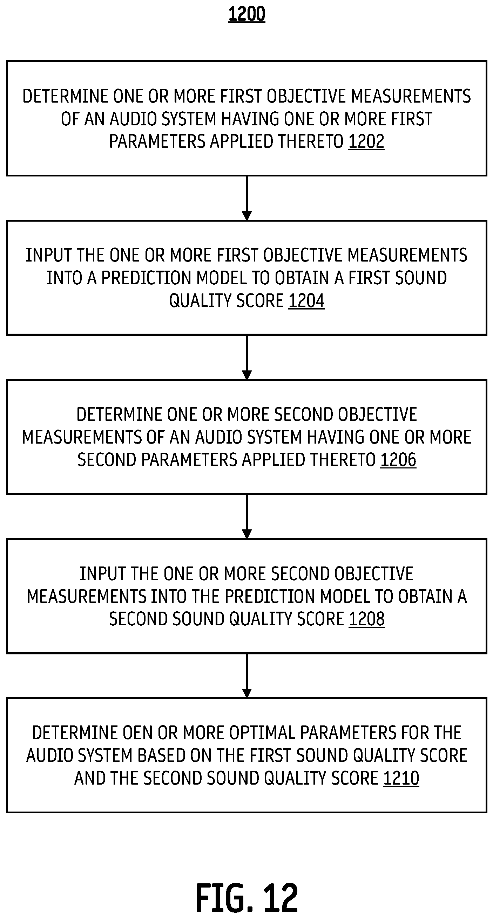

FIG. 12 depicts a flow diagram illustrating method 1200 for optimizing a perceived quality score, according to some embodiments of the disclosure.

In 1202, one or more first objective measurements of an audio system are determined, the audio system having one or more first parameters applied thereto.

In 1204, the one or more first objective measurements are input into a predictive model to obtain a first sound quality score.

In 1206, one or more second objective measurements of the audio system are determined, the audio system having one or more second parameters applied thereto.

In 1208, the one or more second objective measurements are input into the predictive model to obtain a second sound quality score.

In 1210, one or more optimal parameters for the audio system are determined based on the first sound quality score and the second sound quality score.

### Exemplary computing device

FIG. 13 is a block diagram of an exemplary computing device 1300, according to some embodiments of the disclosure. One or more computing devices 1300 may be used to implement the functionalities described with the FIGS. and herein. A number of components are illustrated in FIG. 13 as included in computing device 1300, but any one or more of these components may be omitted or duplicated, as suitable for the application. In some embodiments, some or all of the components included in the computing device 1300 may be attached to one or more motherboards. In some embodiments, some or all of these components are fabricated onto a single SoC die. Additionally, in various embodiments, the computing device 1300 may not include one or more of the components illustrated in FIG. 13, and the computing device 1300 may include interface circuitry for coupling to the one or more components. For example, the computing device 1300 may not include a display device 1306, and may include display device interface circuitry (e.g., a connector and driver circuitry) to which a display device 1306 may be coupled. In another set of examples, the computing device 1300 may not include an audio input device 1318 or an audio output device 1308 and may include audio input or output device interface circuitry (e.g., connectors and supporting circuitry) to which an audio input device 1318 or audio output device 1308 may be coupled.

The computing device 1300 may include a processing device 1302 (e.g., one or more processing devices, one or more of the same type of processing device, one or more of different types of processing device). The processing device 1302 may include electronic circuitry that process electronic data from data storage elements (e.g., registers, memory, resistors, capacitors, quantum bit cells) to transform that electronic data into other electronic data that may be stored in registers and/or memory. Examples of processing device 1302 may include a CPU, a GPU, a quantum processor, a machine learning processor, an artificial intelligence processor, a neural network processor, an artificial intelligence accelerator, an application specific integrated circuit (ASIC), an analog signal processor, an analog computer, a microprocessor, a digital signal processor, a field programmable gate array (FPGA), a tensor processing unit (TPU), a data processing unit (DPU), etc.

The computing device 1300 may include a memory 1304, which may itself include one or more memory devices such as volatile memory (e.g., DRAM), nonvolatile memory (e.g., read-only memory (ROM)), high bandwidth memory (HBM), flash memory, solid state memory, and/or a hard drive. Memory 1304 includes one or more non-transitory computer-readable storage media. In some embodiments, memory 1304 may include memory that shares a die with the processing device 1302.

In some embodiments, memory 1304 includes one or more non-transitory computer-readable media storing instructions executable to perform operations described herein (e.g., operations described in FIGS. 2-4 and 7-10, etc.). Memory 1304 may store instructions that encode one or more exemplary parts, components, or modules. In some embodiments, memory 1304 may store instructions that encode data and/or one or more components illustrated in FIGS. FIGS. 2-4 and 7-10, such as components illustrated in process 400, SPL data collection system 1002, and tuning as a service system 1000. The instructions stored in the one or more non-transitory computer-readable media may be executed by processing device 1302. In some embodiments, memory 1304 may store instructions that cause the processing device 1302 to execute one or more methods (or one or more operations thereof), such as method 1100 and method 1200. In some embodiments, memory 1304 may store data, e.g., data structures, binary data, bits, metadata, files, blobs, etc., as described herein, such as data illustrated in FIGS. 2-4 and 7-10.

In some embodiments, the computing device 1300 may include a communication device 1312 (e.g., one or more communication devices). For example, the communication device 1312 may be configured for managing wired and/or wireless communications for the transfer of data to and from the computing device 1300. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not. The communication device 1312 may implement any of a number of wireless standards or protocols, including but not limited to Institute for Electrical and Electronic Engineers (IEEE) standards including Wi-Fi (IEEE 802.10 family), IEEE 802.16 standards (e.g., IEEE 802.16-2005 Amendment), Long-Term Evolution (LTE) project along with any amendments, updates, and/or revisions (e.g., advanced LTE project, ultramobile broadband (UMB) project (also referred to as "3GPP2"), etc.). IEEE 802.16 compatible Broadband Wireless Access (BWA) networks are generally referred to as WiMAX networks, an acronym that stands for worldwide interoperability for microwave access, which is a certification mark for products that pass conformity and interoperability tests for the IEEE 802.16 standards. The communication device 1312 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication device 1312 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication device 1312 may operate in accordance with Code-division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication device 1312 may operate in accordance with other wireless protocols in other embodiments. The computing device 1300 may include an antenna 1322 to facilitate wireless communications and/or to receive other wireless communications (such as radio frequency transmissions). The computing device 1300 may include receiver circuits and/or transmitter circuits. In some embodiments, the communication device 1312 may manage wired communications, such as electrical, optical, or any other suitable communication protocols (e.g., the Ethernet). As noted above, the communication device 1312 may include multiple communication chips. For instance, a first communication device 1312 may be dedicated to shorter-range wireless communications such as Wi-Fi or Bluetooth, and a second communication device 1312 may be dedicated to longer-range wireless communications such as global positioning system (GPS), EDGE, GPRS, CDMA, WiMAX, LTE, EV-DO, or others. In some embodiments, a first communication device 1312 may be dedicated to wireless communications, and a second communication device 1312 may be dedicated to wired communications.

The computing device 1300 may include power source / power circuitry 1314. The power source / power circuitry 1314 may include one or more energy storage devices (e.g., batteries or capacitors) and/or circuitry for coupling components of the computing device 1300 to an energy source separate from the computing device 1300 (e.g., DC power, AC power, etc.).

The computing device 1300 may include a display device 1306 (or corresponding interface circuitry, as discussed above). The display device 1306 may include any visual indicators, such as a heads-up display, a computer monitor, a projector, a touchscreen display, a liquid crystal display (LCD), a LED display, or a flat panel display, for example.

The computing device 1300 may include an audio output device 1308 (or corresponding interface circuitry, as discussed above). The audio output device 1308 may include any device that generates an audible indicator, such as speakers, headsets, or earbuds, for example.

The computing device 1300 may include an audio input device 1318 (or corresponding interface circuitry, as discussed above). The audio input device 1318 may include any device that generates a signal representative of a sound, such as microphones, microphone arrays, or digital instruments (e.g., instruments having a musical instrument digital interface (MIDI) output). In some embodiments, the audio input device 1318 is a remote control having a microphone. In some embodiments, the audio input device 1318 is a mobile device communicably connected with computing device 1300, where the mobile device has a microphone.

The computing device 1300 may include a GPS device 1316 (or corresponding interface circuitry, as discussed above). The GPS device 1316 may be in communication with a satellite-based system and may receive a location of the computing device 1300, as known in the art.

The computing device 1300 may include a sensor 1330 (or one or more sensors). The computing device 1300 may include corresponding interface circuitry, as discussed above). Sensor 1330 may sense physical phenomenon and translate the physical phenomenon into electrical signals that can be processed by, e.g., processing device 1302. Examples of sensor 1330 may include: capacitive sensor, inductive sensor, resistive sensor, electromagnetic field sensor, light sensor, camera, imager, microphone, pressure sensor, temperature sensor, vibrational sensor, accelerometer, gyroscope, strain sensor, moisture sensor, humidity sensor, distance sensor, range sensor, time-of-flight sensor, pH sensor, particle sensor, air quality sensor, chemical sensor, gas sensor, biosensor, ultrasound sensor, a scanner, etc.

The computing device 1300 may include another output device 1310 (or corresponding interface circuitry, as discussed above). Examples of the other output device 1310 may include an audio codec, a video codec, a printer, a wired or wireless transmitter for providing information to other devices, haptic output device, gas output device, vibrational output device, lighting output device, home automation controller, or an additional storage device.

The computing device 1300 may include another input device 1320 (or corresponding interface circuitry, as discussed above). Examples of the other input device 1320 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

The computing device 1300 may have any desired form factor, such as a handheld or mobile computer system (e.g., a cell phone, a smart phone, a mobile Internet device, a music player, a tablet computer, a laptop computer, a netbook computer, a personal digital assistant (PDA), an ultramobile personal computer, a remote control, wearable device, headgear, eyewear, footwear, electronic clothing, etc.), a desktop computer system, a server or other networked computing component, a printer, a scanner, a monitor, a set-top box, an entertainment control unit, a television, a media player, a vehicle control unit, a digital camera, a digital video recorder, an Internet-of-Things device (e.g., light bulb, cable, power plug, power source, lighting system, audio assistant, audio speaker, smart home device, smart thermostat, camera monitor device, sensor device, smart home doorbell, motion sensor device), a virtual reality system, an augmented reality system, a mixed reality system, or a wearable computer system. In some embodiments, the computing device 1300 may be any other electronic device that processes data.

### Exemplary results

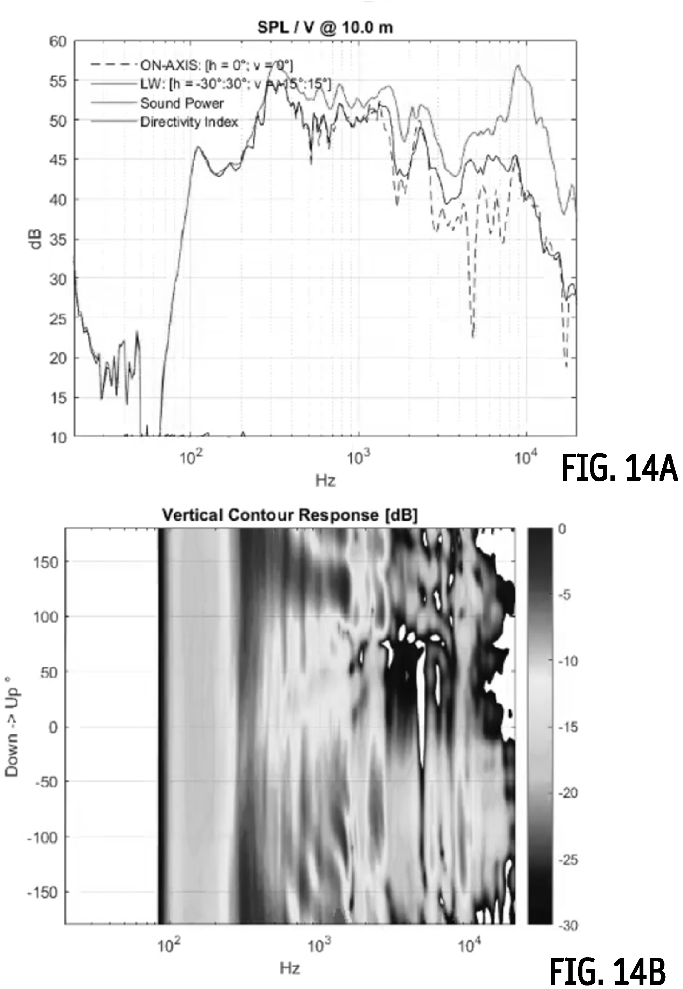

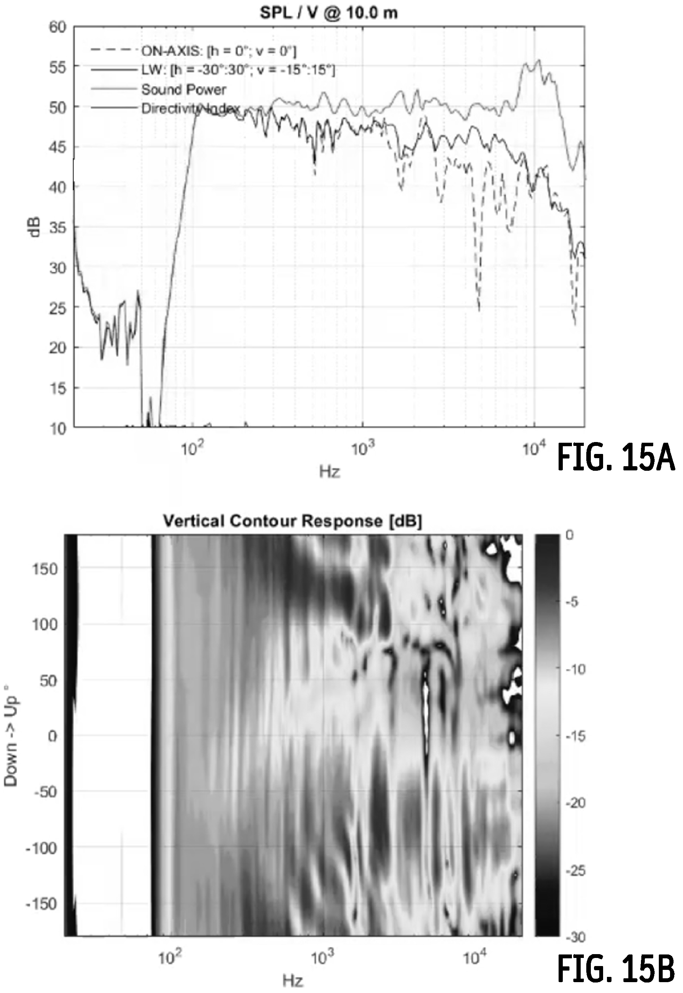

FIGS. 14A-B depict data plots of an integrated audio system without tuning, according to some embodiments of the disclosure. FIGS. 15A-B depict data plots of the same integrated audio system but with tuning, according to some embodiments of the disclosure. The tuning was performed using the system illustrated in FIG. 4. The response curves and contour response in FIGS. 15A-B illustrate significant improvement in the smoothness and uniformity of the audio. The predicted sound quality score without tuning was 2.6. The predicted sound quality score with tuning is 3.9.

### Exemplary objective measurements and data plots

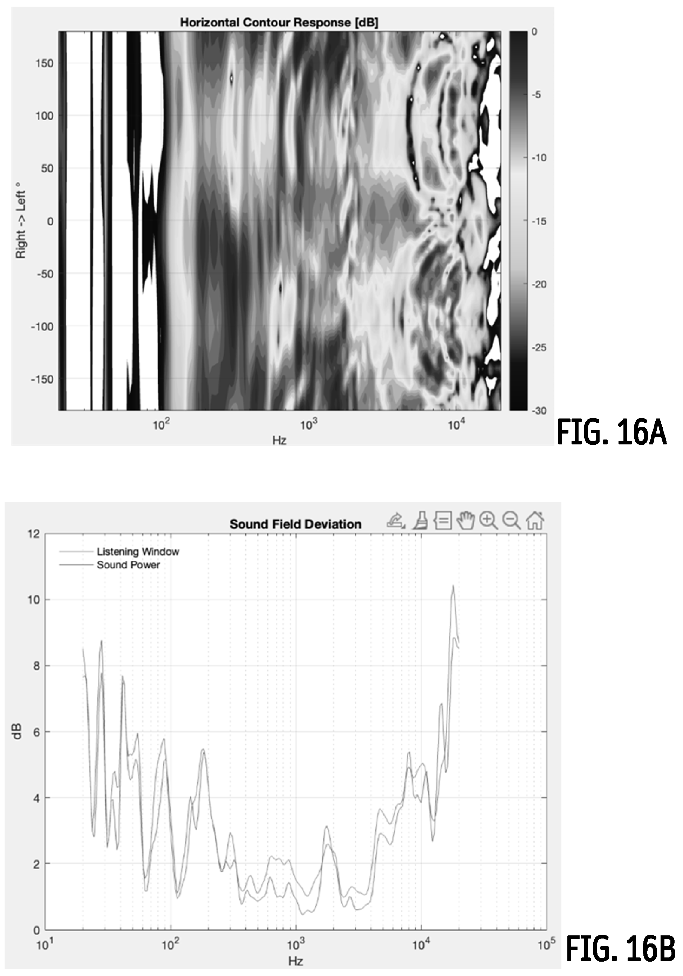

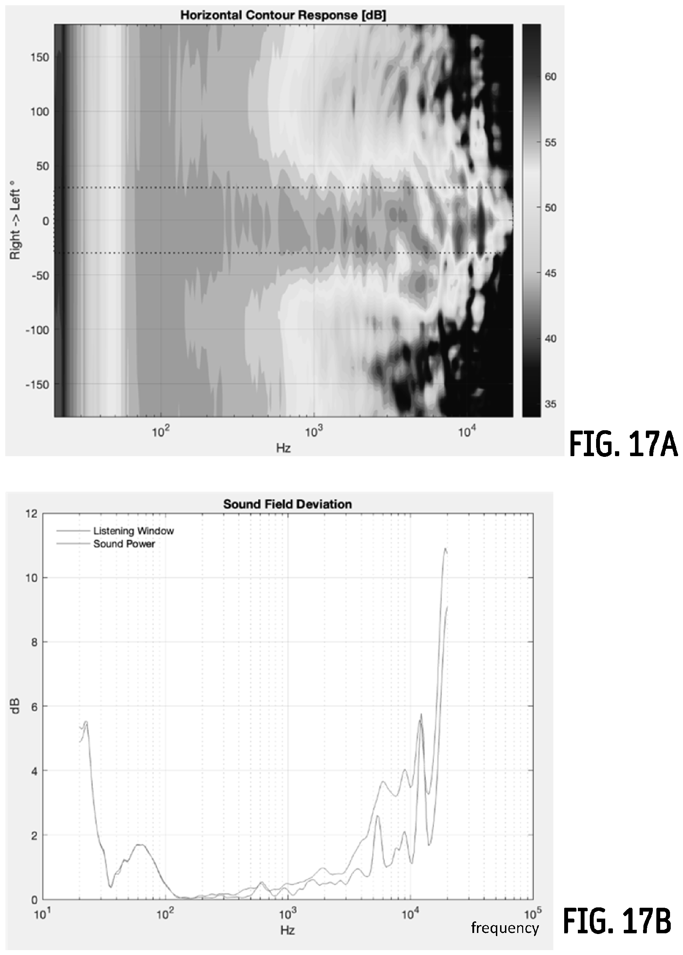

FIG. 16A depicts an exemplary horizontal contour response of an integrated audio system, according to some embodiments of the disclosure. FIG. 16B depicts an exemplary sound field deviation plotted over frequency of the integrated audio system, according to some embodiments of the disclosure. FIG. 17A depicts an exemplary horizontal contour response of an external audio system, according to some embodiments of the disclosure. FIG. 17B depicts an exemplary sound field deviation plotted over frequency of the external audio system, according to some embodiments of the disclosure.

Comparing FIG. 16A and FIG. 17A visually, the spatial variation (e.g., point-to-point variation) is significantly higher for the integrated audio system than the spatial variation of the external audio system. Sound field deviation plots for the listening window and for the overall sound power depicted in FIG. 16B and FIG. 17B illustrate the amount of error or difference between the actual response and a flat response at various frequencies. One or more spatial variation measurements (e.g., measurements made by spatial variation measurements 708 of FIG. 7) can be extracted from the sound field deviation plots. An objective measurement relating to spatial variance can include a sum of the sound field deviation over frequency to produce a score that quantifies spatial variance. Another objective measurement relating to spatial variance can include an average of the sound field deviation over frequency. Another objective measurement relating to spatial variance can include a statistic of the sound field deviation over frequency (e.g., median, mode, mean with outliers removed, etc.).

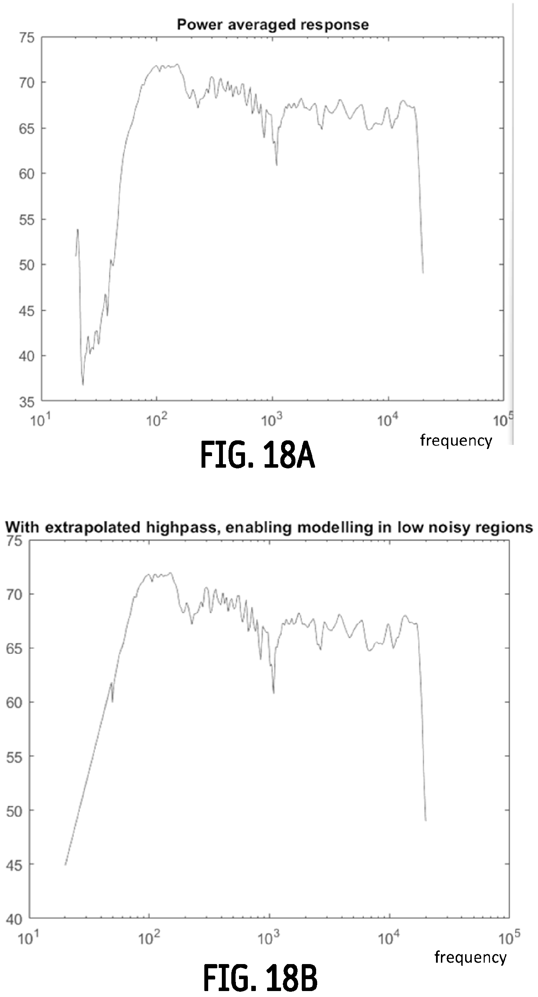

FIG. 18A depicts an exemplary power averaged frequency response, according to some embodiments of the disclosure. FIG. 18B depicts an exemplary power averaged frequency response with extrapolated high-pass, according to some embodiments of the disclosure. In particular, FIG. 18B shows the power averaged frequency response of FIG. 18A with an extrapolation of what the power averaged frequency response of FIG. 18A would look like under conditions with little to no noise. The extrapolated version of the power averaged frequency response of FIG. 18A may be used to improve the results of fitting a first order, second order, or a fourth order high-pass model to the response.

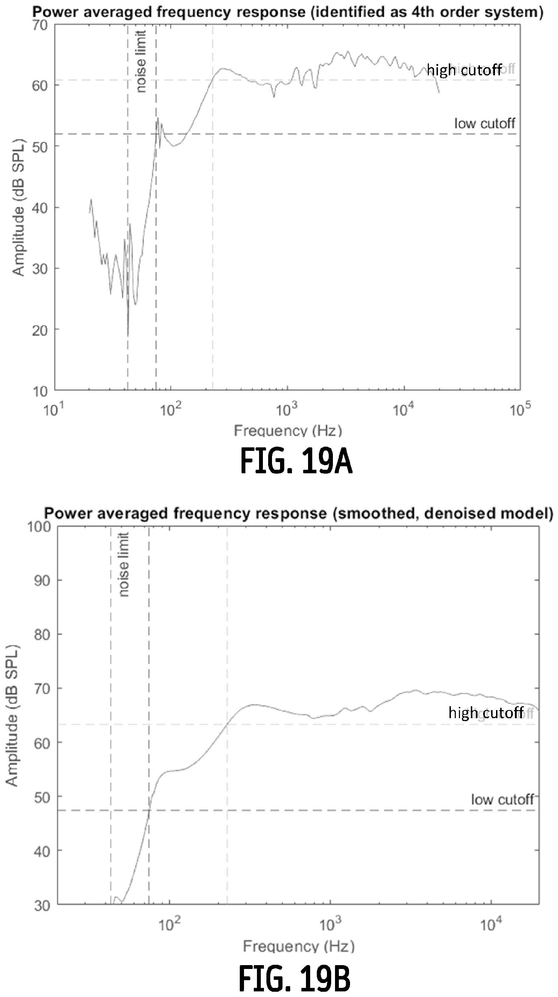

FIG. 19A depicts an exemplary power averaged frequency response, according to some embodiments of the disclosure. FIG. 19B depicts an exemplary power averaged frequency response with smoothed denoised model, according to some embodiments of the disclosure. The power averaged frequency response of FIG. 19A may exhibit a best fit with a fourth order high-pass model (the audio system may be a ported system). Based on the fourth order high-pass model, the smoothed denoised version of the power averaged frequency response can be analyzed to extract one or more non-linearity measurements, such as measurements relating to cutoff.

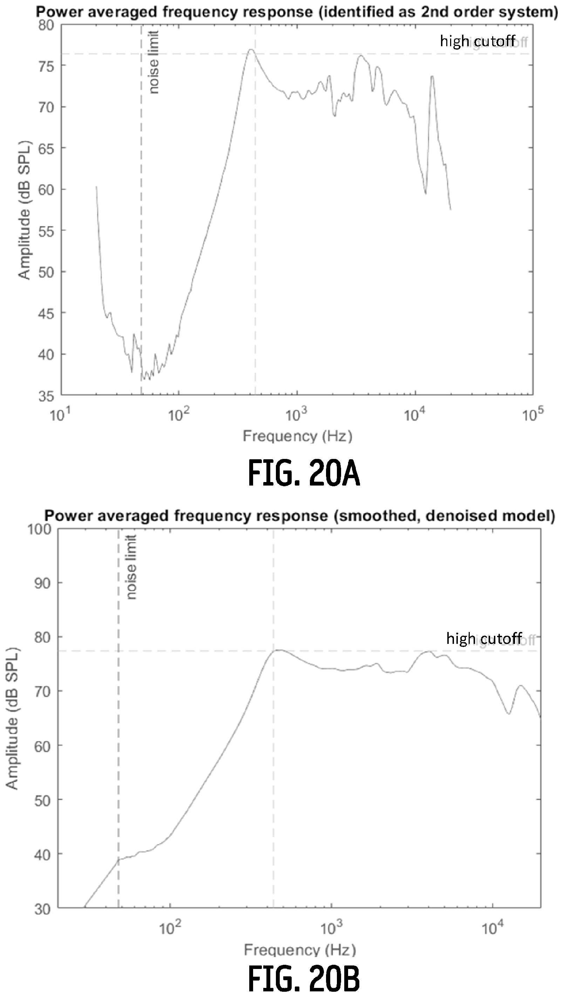

FIG. 20A depicts an exemplary power averaged frequency response, according to some embodiments of the disclosure. FIG. 20B depicts an exemplary power averaged frequency response with smoothed denoised model, according to some embodiments of the disclosure. The power averaged frequency response of FIG. 20A may exhibit a best fit with a second order high-pass model (the audio system may be a unported system). Based on the fourth order high-pass model, the smoothed denoised version of the power averaged frequency response can be analyzed to extract one or more non-linearity measurements, such as measurements relating to cutoff, such as base cutoff, cut off change slope, maximum cutoff, start cutoff level, cutoff level change slope, max cutoff level.

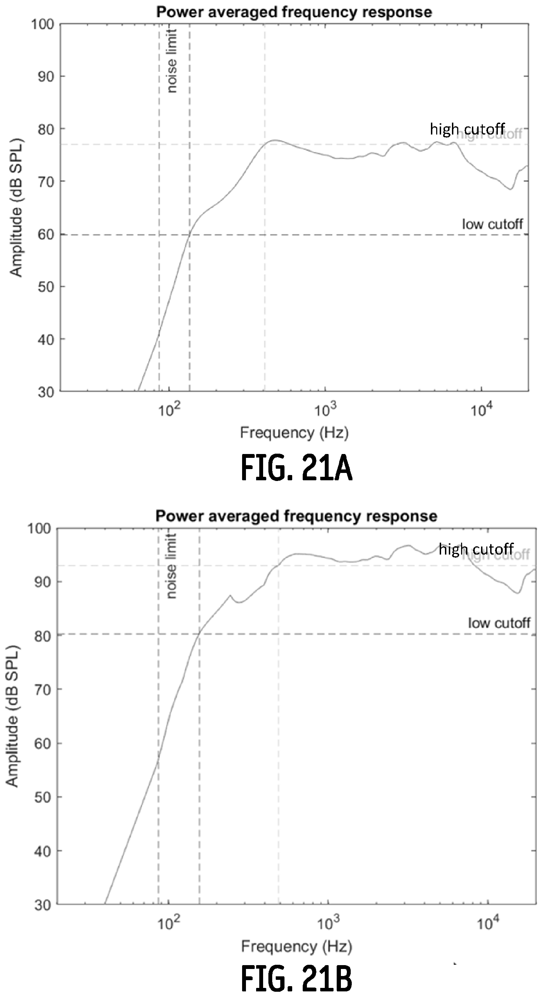

FIG. 21A depicts an exemplary power averaged frequency response at a first level, according to some embodiments of the disclosure. FIG. 21B depicts an exemplary power averaged frequency response at a second level, according to some embodiments of the disclosure. Note that the cutoffs change as the level changes. The performance of the audio system changes as a function of the level or volume (e.g., how loud the audio system is playing). The first level may be the starting level or volume (e.g., a low output volume). The second level may be the maximum level or volume that the audio system can safely play at (e.g., a high output volume). The power averaged frequency responses are obtained by applying volume gains at different frequencies found in the maximum SPL test. The power averaged frequency response changes as the level or volume becomes higher as the audio system (which is an active system) is trying to protect the driver from harm at high volumes. The effect is that the modeled high-pass cutoffs have moved up, indicating worse bass performance of the audio system as output gain increases. The power averaged frequency responses at different levels can be analyzed to extract one or more non-linearity measurements, such as measurements relating to cutoff, such as base cutoff, cut off change slope, maximum cutoff, start cutoff level, cutoff level change slope, max cutoff level. A non-linearity measurement, which may quantify how the the high to low cutoff region rises as volume/level changes is made worse as volume gets higher. For some audio systems, the high to low cutoff region rising 1 dB for 1 dB of volume change can be a predictor for a good perceived quality score.

### Select examples

Example 1 provides a method for predicting sound quality, including acquiring a spherical sound pressure level measurement of an audio system; extracting one or more objective measurements from the spherical sound pressure level measurement, the one or more objective measurements including a spatial variance measurement; and inputting the one or more objective measurements into a predictive model to obtain a sound quality score of the audio system.

Example 2 provides the method of example 1, where acquiring the spherical sound pressure level measurement includes beamforming a microphone array to make measurements on a spherical surface.

Example 3 provides the method of example 1 or 2, where acquiring the spherical sound pressure level measurement includes moving a microphone to make sound pressure level measurements on a spherical surface.

Example 4 provides the method of any one of examples 1-3, where acquiring the spherical sound pressure level measurement includes rotating the audio system to allow a microphone to make sound pressure level measurements on a spherical surface.

Example 5 provides the method of any one of examples 1-4, further including acquiring a voltage measurement of a speaker clamp of the audio system.

Example 6 provides the method of example 5, where the spherical sound pressure level measurement is divided by the voltage measurement.

Example 7 provides the method of any one of examples 1-6, where the spatial variance measurement quantifies variations of sound pressure level across frequency and space.

Example 8 provides the method of any one of examples 1-7, where the one or more objective measurements include a direct sound balance measurement.

Example 9 provides the method of any one of examples 1-8, where the one or more objective measurements include a direct sound quality measurement quantifying a flatness or an amount of errors in a frequency response of direct sound.

Example 10 provides the method of any one of examples 1-9, where the one or more objective measurements include a power balance measurement over both direct sound and indirect sound.

Example 11 provides the method of any one of examples 1-10, where the one or more objective measurements include a power quality measurement quantifying a flatness or an amount of errors in a frequency response of both direct sound and indirect sound.

Example 12 provides the method of any one of examples 1-11, where the one or more objective measurements include a forward directivity measurement quantifying a frequency-dependent ratio between direct sound and indirect sound.

Example 13 provides the method of any one of examples 1-12, where the one or more objective measurements include an intermodulation distortion score.

Example 14 provides the method of any one of examples 1-13, where the one or more objective measurements include a volume displacement measurement quantifying how loud the audio system can produce an audio output and maintain a level of performance.

Example 15 provides the method of any one of examples 1-14, where the one or more objective measurements include a low frequency extension measurement quantifying a lowest frequency the audio system can produce an audio output.

Example 16 provides the method of any one of examples 1-15, where the predictive model includes a multivariate linear regression model.

Example 17 provides the method of any one of examples 1-16, where the predictive model includes a machine learning model.

Example 18 provides the method of any one of examples 1-17, where the audio system is integrated in a television.

Example 19 provides one or more non-transitory computer-readable media storing instructions that, when executed by one or more processors, cause the one or more processors to: acquire a spherical sound pressure level measurement of an audio system; extract one or more objective measurements from the spherical sound pressure level measurement, the one or more objective measurements including a spatial variance measurement; and input the one or more objective measurements into a predictive model to obtain a sound quality score of the audio system.

Example 20 provides the one or more non-transitory computer-readable media of example 19, where acquiring the spherical sound pressure level measurement includes beamforming a microphone array to make measurements on a spherical surface.

Example 21 provides the one or more non-transitory computer-readable media of example 19 or 20, where acquiring the spherical sound pressure level measurement includes moving a microphone to make sound pressure level measurements on a spherical surface.

Example 22 provides the one or more non-transitory computer-readable media of any one of examples 19-21, where acquiring the spherical sound pressure level measurement includes rotating the audio system to allow a microphone to make sound pressure level measurements on a spherical surface.

Example 23 provides the one or more non-transitory computer-readable media of any one of examples 19-22, where the instructions further cause the one or more processors to acquire a voltage measurement of a speaker clamp of the audio system.

Example 24 provides the one or more non-transitory computer-readable media of example 23, where the spherical sound pressure level measurement is divided by the voltage measurement.

Example 25 provides the one or more non-transitory computer-readable media of any one of examples 19-24, where the spatial variance measurement quantifies variations of sound pressure level across frequency and space.

Example 26 provides the one or more non-transitory computer-readable media of any one of examples 19-25, where the one or more objective measurements include a direct sound balance measurement.

Example 27 provides the one or more non-transitory computer-readable media of any one of examples 19-26, where the one or more objective measurements include a direct sound quality measurement quantifying a flatness or an amount of errors in a frequency response of direct sound.

Example 28 provides the one or more non-transitory computer-readable media of any one of examples 19-27, where the one or more objective measurements include a power balance measurement over both direct sound and indirect sound.

Example 29 provides the one or more non-transitory computer-readable media of any one of examples 19-28, where the one or more objective measurements include a power quality measurement quantifying a flatness or an amount of errors in a frequency response of both direct sound and indirect sound.

Example 30 provides the one or more non-transitory computer-readable media of any one of examples 19-29, where the one or more objective measurements include a forward directivity measurement quantifying a frequency-dependent ratio between direct sound and indirect sound.

Example 31 provides the one or more non-transitory computer-readable media of any one of examples 19-30, where the one or more objective measurements include an intermodulation distortion score.

Example 32 provides the one or more non-transitory computer-readable media of any one of examples 19-31, where the one or more objective measurements include a volume displacement measurement quantifying how loud the audio system can produce an audio output and maintain a level of performance.

Example 33 provides the one or more non-transitory computer-readable media of any one of examples 19-32, where the one or more objective measurements include a low frequency extension measurement quantifying a lowest frequency the audio system can produce an audio output.

Example 34 provides the one or more non-transitory computer-readable media of any one of examples 19-33, where the predictive model includes a multivariate linear regression model.

Example 35 provides the one or more non-transitory computer-readable media of any one of examples 19-34, where the predictive model includes a machine learning model.

Example 36 provides the one or more non-transitory computer-readable media of any one of examples 19-35, where the audio system is integrated in a television.

Example 37 provides an apparatus, including one or more processors; and one or more non-transitory computer-readable media storing instructions that, when executed by the one or more processors, cause the one or more processors to: acquire a spherical sound pressure level measurement of an audio system; extract one or more objective measurements from the spherical sound pressure level measurement, the one or more objective measurements including a spatial variance measurement; and input the one or more objective measurements into a predictive model to obtain a sound quality score of the audio system.

Example 38 provides the apparatus of example 37, where acquiring the spherical sound pressure level measurement includes beamforming a microphone array to make measurements on a spherical surface.

Example 39 provides the apparatus of example 37 or 38, where acquiring the spherical sound pressure level measurement includes moving a microphone to make sound pressure level measurements on a spherical surface.

Example 40 provides the apparatus of any one of examples 37-39, where acquiring the spherical sound pressure level measurement includes rotating the audio system to allow a microphone to make sound pressure level measurements on a spherical surface.

Example 41 provides the apparatus of any one of examples 37-40, where the instructions further cause the one or more processors to acquire a voltage measurement of a speaker clamp of the audio system.

Example 42 provides the apparatus of example 41, where the spherical sound pressure level measurement is divided by the voltage measurement.

Example 43 provides the apparatus of any one of examples 37-42, where the spatial variance measurement quantifies variations of sound pressure level across frequency and space.

Example 44 provides the apparatus of any one of examples 37-43, where the one or more objective measurements include a direct sound balance measurement.

Example 45 provides the apparatus of any one of examples 37-44, where the one or more objective measurements include a direct sound quality measurement quantifying a flatness or an amount of errors in a frequency response of direct sound.

Example 46 provides the apparatus of any one of examples 37-45, where the one or more objective measurements include a power balance measurement over both direct sound and indirect sound.

Example 47 provides the apparatus of any one of examples 37-46, where the one or more objective measurements include a power quality measurement quantifying a flatness or an amount of errors in a frequency response of both direct sound and indirect sound.

Example 48 provides the apparatus of any one of examples 37-47, where the one or more objective measurements include a forward directivity measurement quantifying a frequency-dependent ratio between direct sound and indirect sound.

Example 49 provides the apparatus of any one of examples 37-48, where the one or more objective measurements include an intermodulation distortion score.

Example 50 provides the apparatus of any one of examples 37-49, where the one or more objective measurements include a volume displacement measurement quantifying how loud the audio system can produce an audio output and maintain a level of performance.

Example 51 provides the apparatus of any one of examples 37-50, where the one or more objective measurements include a low frequency extension measurement quantifying a lowest frequency the audio system can produce an audio output.

Example 52 provides the apparatus of any one of examples 37-51, where the predictive model includes a multivariate linear regression model.

Example 53 provides the apparatus of any one of examples 37-52, where the predictive model includes a machine learning model.

Example 54 provides the apparatus of any one of examples 37-53, where the audio system is integrated in a television.

Example A provides a computer program product comprising instructions, that when executed by a processor, causes the processor to perform a method of any one of examples 1-18.

Example B provides an apparatus comprising means for performing a method of any one of examples 1-18.

Example C provides an objective measurement system as described herein.

Example D provides a perceived quality model as described herein.

Example E provides a system comprising one or more components as illustrated in any one of FIGS. 1-4, and 7-10.

### Variations and other notes

Although the operations of the example methods shown in and described with reference to the FIGS. are illustrated as occurring once each and in a particular order, it will be recognized that the operations may be performed in any suitable order and repeated as desired. Additionally, one or more operations may be performed in parallel. Furthermore, the operations illustrated in the FIGS. may be combined or may include more or fewer details than described.

The above description of illustrated implementations of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize. These modifications may be made to the disclosure in light of the above detailed description.

For purposes of explanation, specific numbers, materials and configurations are set forth in order to provide a thorough understanding of the illustrative implementations. However, it will be apparent to one skilled in the art that the present disclosure may be practiced without the specific details and/or that the present disclosure may be practiced with only some of the described aspects. In other instances, well known features are omitted or simplified in order not to obscure the illustrative implementations.

Further, references are made to the accompanying drawings that form a part hereof, and in which are shown, by way of illustration, embodiments that may be practiced. It is to be understood that other embodiments may be utilized, and structural or logical changes may be made without departing from the scope of the present disclosure. Therefore, the following detailed description is not to be taken in a limiting sense.

Various operations may be described as multiple discrete actions or operations in turn, in a manner that is most helpful in understanding the disclosed subject matter. However, the order of description should not be construed as to imply that these operations are necessarily order dependent. In particular, these operations may not be performed in the order of presentation. Operations described may be performed in a different order from the described embodiment. Various additional operations may be performed or described operations may be omitted in additional embodiments.

For the purposes of the present disclosure, the phrase "A or B" or the phrase "A and/or B" means (A), (B), or (A and B). For the purposes of the present disclosure, the phrase "A, B, or C" or the phrase "A, B, and/or C" means (A), (B), (C), (A and B), (A and C), (B and C), or (A, B, and C). The term "between," when used with reference to measurement ranges, is inclusive of the ends of the measurement ranges.

The description uses the phrases "in an embodiment" or "in embodiments," which may each refer to one or more of the same or different embodiments. The terms "comprising," "including," "having," and the like, as used with respect to embodiments of the present disclosure, are synonymous. The disclosure may use perspective-based descriptions such as "above," "below," "top," "bottom," and "side" to explain various features of the drawings, but these terms are simply for ease of discussion, and do not imply a desired or required orientation. The accompanying drawings are not necessarily drawn to scale. Unless otherwise specified, the use of the ordinal adjectives "first," "second," and "third," etc., to describe a common object, merely indicates that different instances of like objects are being referred to and are not intended to imply that the objects so described must be in a given sequence, either temporally, spatially, in ranking or in any other manner.

In the following detailed description, various aspects of the illustrative implementations will be described using terms commonly employed by those skilled in the art to convey the substance of their work to others skilled in the art.

The terms "substantially," "close," "approximately," "near," and "about," generally refer to being within +/- 20% of a target value as described herein or as known in the art. Similarly, terms indicating orientation of various elements, e.g., "coplanar," "perpendicular," "orthogonal," "parallel," or any other angle between the elements, generally refer to being within +/- 5-20% of a target value as described herein or as known in the art.

In addition, the terms "comprise," "comprising," "include," "including," "have," "having" or any other variation thereof, are intended to cover a non-exclusive inclusion. For example, a method, process, or device, that comprises a list of elements is not necessarily limited to only those elements but may include other elements not expressly listed or inherent to such method, process, or device. Also, the term "or" refers to an inclusive "or" and not to an exclusive "or."

The systems, methods and devices of this disclosure each have several innovative aspects, no single one of which is solely responsible for all desirable attributes disclosed herein. Details of one or more implementations of the subject matter described in this specification are set forth in the description and the accompanying drawings.

## Claims

1. A method for predicting sound quality, comprising:
acquiring a spherical sound pressure level measurement of an audio system, wherein the audio system is optionally integrated in a television;
extracting one or more objective measurements from the spherical sound pressure level measurement, the one or more objective measurements comprising a spatial variance measurement; and
inputting the one or more objective measurements into a predictive model to obtain a sound quality score of the audio system.

2. The method of claim 1, further comprising acquiring a voltage measurement of a speaker clamp of the audio system.

3. The method of claim 2, wherein the spherical sound pressure level measurement is divided by the voltage measurement.

4. The method of any one of claims 1-3, wherein the spatial variance measurement quantifies variations of sound pressure level across frequency and space.

5. The method of any one of claims 1-4, wherein the one or more objective measurements comprise a direct sound balance measurement.

6. The method of any one of claims 1-5, wherein the one or more objective measurements comprise a direct sound quality measurement quantifying a flatness or an amount of errors in a frequency response of direct sound.

7. The method of any one of claims 1-6, wherein the one or more objective measurements comprise a power balance measurement over both direct sound and indirect sound.

8. The method of any one of claims 1-7, wherein the one or more objective measurements comprise a power quality measurement quantifying a flatness or an amount of errors in a frequency response of both direct sound and indirect sound.

9. The method of any one of claims 1-8, wherein the one or more objective measurements comprise a forward directivity measurement quantifying a frequency-dependent ratio between direct sound and indirect sound.

10. The method of any one of claims 1-9, wherein the one or more objective measurements comprise an intermodulation distortion score.

11. The method of any one of claims 1-10, wherein the one or more objective measurements comprise a volume displacement measurement quantifying how loud the audio system can produce an audio output and maintain a level of performance.

12. The method of any one of claims 1-11, wherein the one or more objective measurements comprise a low frequency extension measurement quantifying a lowest frequency the audio system can produce an audio output.

13. The method of any one of claims 1-12, wherein the predictive model comprises one or more of a multivariate linear regression model and a machine learning model.

14. One or more non-transitory computer-readable media storing instructions that, when executed by one or more processors, cause the one or more processors to perform a method according to one of claims 1-13.

15. An apparatus, comprising:
one or more processors; and
one or more non-transitory computer-readable media storing instructions that, when executed by the one or more processors, cause the one or more processors to perform a method according to one of claims 1-13.
